# EUROPÄISCHE PATENTSCHRIFT

(11) **EP 3 175 685 B1**
(45) Veröffentlichungstag und Bekanntmachung des Hinweises auf die Patenterteilung: **29.01.2020**
(21) Anmeldenummer: 15739518.7
(22) Anmeldetag: 15.07.2015
(51) Int. Cl.: H05K 5/02, H05K 7/14, H02G 3/14

(54) **ELEKTROGERÄT, INSBESONDERE UMRICHTER**
ELECTRIC DEVICE, IN PARTICULAR CONVERTER
APPAREIL ÉLECTRIQUE, EN PARTICULIER ONDULEUR

(30) Priorität: 30.07.2014 DE 102014011084
(43) Veröffentlichungstag der Anmeldung: 07.06.2017
(73) Patentinhaber: SEW-EURODRIVE GmbH & Co. KG, 76646 Bruchsal (DE)
(72) Erfinder: EHRET, Denise, 76133 Karlsruhe (DE); NIKOLA, Joachim, 76703 Kraichtal (DE)
(86) Internationale Anmeldenummer: PCT/EP2015/001450
(87) Internationale Veröffentlichungsnummer: WO 2016/015831

(56) Entgegenhaltungen:
- EP-A2- 1 944 845
- EP-A2- 1 956 685
- GB-A- 442 364
- US-A1- 2013 084 050

## Beschreibung

Die Erfindung betrifft ein Elektrogerät, insbesondere Umrichter.

Aus der DE 10 2011 119 490 A1 ist ein Elektrogerät, insbesondere Umrichter, mit einem Deckelteil bekannt.

**Die** GB 442 364 A zeigt eine Box, die mittels einer Drehverbindung mit einem Abdeckteil verbunden ist.

In der EP 1 944 845 A2 ist ein elektrischer Anschlusskasten offenbart.

Der Erfindung liegt daher die Aufgabe zugrunde, ein Elektrogerät weiterzubilden, wobei die Sicherheit verbessert werden soll.

Erfindungsgemäß wird die Aufgabe bei dem Elektrogerät nach den in Anspruch 1 angegebenen Merkmalen gelöst.

Wichtige Merkmale der Erfindung bei dem Elektrogerät, insbesondere Umrichter, aufweisend ein Gehäuse und ein Deckelteil sind, dass
das Deckelteil an dem Gehäuse schwenkbar gelagert ist, insbesondere wobei das Deckelteil lösbar mit dem Gehäuse verbunden ist,
indem das Deckelteil einen Zapfen aufweist, der in einem Lagerabschnitt, insbesondere einer Vertiefung, des Gehäuses, aufgenommen ist,
wobei ein Verriegelungsmittel mit einem Gehäuseteil des Gehäuses formschlüssig verbunden ist, insbesondere klipsverbunden,
wobei das Deckelteil mittels des Verriegelungsmittels am Gehäuse verriegelbar ist, insbesondere mit dem Verriegelungsmittel klipsverbindbar ist.

Von Vorteil ist dabei, dass das Verriegelungsmittel in einfacher Art und Weise verbindbar ist mit dem Gehäuseteil. Vorteilhafterweise ist das Verriegelungsmittel elastischer ausführbar als das Gehäuseteil. Das Verriegelungsmittel ist austauschbar, so dass bei einem Defekt des Verriegelungsmittels, dieses mit geringem Aufwand auswechselbar ist.

Von Vorteil ist weiter, dass Anzeigemittel, Schalter, Steckverbinder und/oder Gegensteckverbinder am Elektrogerät abdeckbar sind mittels des Deckelteils. Somit ist die Sicherheit des Elektrogerätes verbessert, da eine Fehlbedienung bei geschlossenem Deckelteil verhinderbar ist.

Bei einer vorteilhaften Ausgestaltung weist das Verriegelungsmittel zwei Führungsnuten auf, mittels derer das Verriegelungsmittel in einer schlitzförmigen Ausnehmung in dem Gehäuseteil geführt ist. Von Vorteil ist dabei, dass die Führungsnuten die Position des Verriegelungsmittels relativ zum Gehäuseteil festlegen. Mittels zweier Führungsnuten ist dabei ein Verkippen des Verriegelungsmittels verhinderbar.

Bei einer vorteilhaften Ausgestaltung sind die Führungsnuten parallel angeordnet. Von Vorteil ist dabei, dass das Verriegelungsmittel mittels der Führungsnuten fixierbar ist. Die Position der Führungsnuten ist festlegbar relativ zum Gehäuseteil. Bei einer elastischen Verformung des Verriegelungsmittels fungieren die Führungsnuten als Fixpunkte am Gehäuseteil.

Bei einer vorteilhaften Ausgestaltung weisen die Führungsnuten jeweils eine Nutöffnung auf, wobei die Nutöffnungen entgegengesetzt gerichtet sind. Von Vorteil ist dabei, dass die Führungsnuten das Verriegelungsmittel in allen Querrichtungen zur Einführrichtung begrenzen.

Bei einer vorteilhaften Ausgestaltung weist das Verriegelungsmittel einen Vorsprung auf, wobei das Gehäuseteil eine Ausnehmung, insbesondere Bohrung, aufweist, wobei der Vorsprung in die Ausnehmung einführbar, insbesondere einpressbar, ist. Von Vorteil ist dabei, dass das Verriegelungsmittel mittels des Vorsprungs in Einführrichtung begrenzbar ist. Der Vorsprung wird beim Einführen in das Gehäuseteil in die Ausnehmung eingeklipst. Dazu ist das Verriegelungsmittel zumindest abschnittweise elastisch auslenkbar ausgeführt.

Bei einer vorteilhaften Ausgestaltung ist der Vorsprung von einem elastisch vorgespannten Bereich des Verriegelungsmittels in die Ausnehmung hineingedrückt. Von Vorteil ist dabei, dass die auf das Verriegelungsmittel wirkende elastische Kraft das Verriegelungsmittel an dem Gehäuseteil fixiert. Vorteilhaft ist weiter, dass das Verriegelungsmittel zerstörungsfrei aus dem Elektrogerät entnehmbar ist und somit wiederverwendbar ist.

Bei einer vorteilhaften Ausgestaltung ist dadurch die Beweglichkeit des Verriegelungsmittels in der Erstreckungsrichtung der Führungsnuten begrenzt. Von Vorteil ist dabei, dass das Verriegelungsmittel in einfacher Art und Weise lösbar mit dem Gehäuseteil verbindbar ist.

Bei einer vorteilhaften Ausgestaltung ist der Vorsprung beabstandet von den Führungsnuten. Von Vorteil ist dabei, dass das Verriegelungsmittel zwischen dem Vorsprung und den Führungsnuten elastisch verformbar ist. Vorteilhafterweise nimmt die absolute Auslenkbarkeit in Querrichtung zur Erstreckungsrichtung des Verriegelungsmittels zwischen dem Vorsprung und den Führungsnuten mit zunehmendem Abstand zwischen dem Vorsprung und den Führungsnuten zu.

Bei einer vorteilhaften Ausgestaltung weist das Verriegelungsmittel einen Befestigungsabschnitt auf, wobei der Befestigungsabschnitt sich von den Führungsnuten zu dem Vorsprung erstreckt, insbesondere parallel zum Gehäuseteil sich erstreckt, wobei der Befestigungsabschnitt elastisch auslenkbar ist in einer ersten Querrichtung zur Erstreckungsrichtung der Führungsnuten. Von Vorteil ist dabei, dass das Verriegelungsmittel in einfacher Art und Weise verbindbar ist mit dem Gehäuseteil.

Bei einer vorteilhaften Ausgestaltung ist das Verriegelungsmittel in der ersten Querrichtung begrenzt von dem in die Führungsnuten hineinragenden Gehäuseteil. Von Vorteil ist dabei, dass der Berührbereich der Führungsnuten mit dem Gehäuseteil als Fixpunkt fungiert für den elastisch auslenkbaren Befestigungsabschnitt.

Bei einer vorteilhaften Ausgestaltung weist das Verriegelungsmittel einen Verbindungsabschnitt auf, wobei der Verbindungsabschnitt elastisch auslenkbar ist, insbesondere relativ zu den Führungsnuten, in einer zweiten Querrichtung zur Erstreckungsrichtung der Führungsnuten, insbesondere wobei die zweite Querrichtung quer zur ersten Querrichtung orientiert ist. Von Vorteil ist dabei, dass das Verriegelungsmittel mittels des Verbindungsabschnitts lösbar verbindbar ist mit dem Deckelteil. Vorteilhafterweise ist das Deckelteil einklipsbar am Verriegelungsmittel, insbesondere dem Verbindungsabschnitt.

Bei einer vorteilhaften Ausgestaltung weist das Verriegelungsmittel eine sich in Erstreckungsrichtung der Führungsnuten erstreckendende Aussparung auf, insbesondere eine schlitzförmige Aussparung. Von Vorteil ist dabei, dass der Verbindungabschnitt elastisch auslenkbar ist relativ zu den Führungsnuten. Dabei ist das Verriegelungsmittel kompakt ausführbar und die Elastizität des Verbindungsabschnitts erhöht im Vergleich zu einem Verriegelungsmittel ohne Aussparung.

Bei einer vorteilhaften Ausgestaltung ist die Aussparung zwischen den Führungsnuten angeordnet. Von Vorteil ist dabei, dass das Verriegelungsmittel kompakt ausführbar ist.

Bei einer vorteilhaften Ausgestaltung sind der Verbindungsabschnitt und der Befestigungsabschnitt senkrecht zueinander angeordnet. Von Vorteil ist dabei, dass das Verriegelungsmittel kompakt ausführbar ist. Vorteilhafterweise erstrecken sich der Verbindungsabschnitt und der Befestigungsabschnitt jeweils in einer Querrichtung zur Einführrichtung.

Bei einer vorteilhaften Ausgestaltung sind das Verriegelungsmittel und/oder das Deckelteil aus Kunststoff ausgeführt, insbesondere als Kunststoffspritzgussteil. Von Vorteil ist dabei, dass das Verriegelungsmittel und/oder das Deckelteil jeweils in einem einzigen Verfahrensschritt herstellbar sind.

Bei einer vorteilhaften Ausgestaltung ist das Gehäuseteil aus metallischem Material ausgeführt. Von Vorteil ist dabei, dass das Gehäuseteil eine höhere Festigkeit aufweist als das Verriegelungsmittel und/oder das Deckelteil. Das Verriegelungsmittel ist elastisch verformbar relativ zum Gehäuseteil.

Bei einer vorteilhaften Ausgestaltung ist der Lagerabschnitt des Gehäuses aus Kunststoff ausgeführt, insbesondere als Kunststoffspritzgussteil. Von Vorteil ist dabei, dass der Verschleiß aufgrund der Drehreibung in dem Lagerabschnitt reduzierbar ist, da der Lagerabschnitt und das Deckelteil, insbesondere der Zapfen, vergleichbare Festigkeiten aufweisen.

Bei einer vorteilhaften Ausgestaltung weist der Verbindungsabschnitt einen ersten Nasenabschnitt auf, wobei das Deckelteil einen zweiten Nasenabschnitt und eine an den zweiten Nasenabschnitt anschließende Vertiefung aufweist, in die der erste Nasenabschnitt einklipsbar ist. Von Vorteil ist dabei, dass das Deckelteil in einfacher Art und Weise klipsverbindbar ist mit dem Verriegelungsmittel.

Bei einer vorteilhaften Ausgestaltung begrenzt der erste Nasenabschnitt den zweiten Nasenabschnitt in einer Schwenkrichtung des Deckelteils. Von Vorteil ist dabei, dass das Deckelteil einklipsbar ist mittels der Nasenabschnitte.

Bei einer vorteilhaften Ausgestaltung weist der erste Nasenabschnitt eine Fase auf, insbesondere eine Einfädelfase für das Deckelteil. Von Vorteil ist dabei, dass der zweite Nasenabschnitt in einfacher Art und Weise einfädelbar ist entlang der Fase des ersten Nasenabschnitts.

Bei einer vorteilhaften Ausgestaltung weist der zweite Nasenabschnitt eine Fase auf, insbesondere eine Einfädelfase für das Verriegelungsmittel. Von Vorteil ist dabei, dass der erste Nasenabschnitt in einfacher Art und Weise einfädelbar ist entlang der Fase des zweiten Nasenabschnitts.

Bei einer vorteilhaften Ausgestaltung weist der Verbindungsabschnitt einen dritten Nasenabschnitt auf, der zwischen dem ersten Nasenabschnitt und einer der Führungsnuten angeordnet ist. Von Vorteil ist dabei, dass der dritte Nasenabschnitt den zweiten Nasenabschnitt in Erstreckungsrichtung des Verbindungsabschnitts begrenzt.

Bei einer vorteilhaften Ausgestaltung sind der erste Nasenabschnitt und der dritte Nasenabschnitt voneinander beabstandet. Von Vorteil ist dabei, dass der zweite Nasenabschnitt in Erstreckungsrichtung des Verbindungsabschnitts zwischen dem ersten und dem dritten Nasenabschnitt anordenbar ist.

Bei einer vorteilhaften Ausgestaltung ist das Deckelteil an dem Gehäuse des Elektrogerätes schwenkbar gelagert, wobei das Deckelteil in einer ersten Schwenkwinkelposition lösbar ist vom Gehäuse, wobei das Deckelteil in einer zweiten Schwenkwinkelposition verriegelbar ist am Gehäuse, indem das Deckelteil einen Zapfen aufweist, der in einem Lagerabschnitt, insbesondere einer Vertiefung, des Gehäuses aufgenommen ist, wobei der Zapfen in einer Querrichtung zur Schwenkachsrichtung weiter ausgedehnt ausgeformt ist als in einer zur Querrichtung und zur Schwenkachsrichtung senkrechten Richtung.

Von Vorteil ist dabei, dass das Deckelteil in einfacher Art und Weise lösbar ist von dem Gehäuse, indem das Deckelteil in die zweite Schwenkwinkelposition geschwenkt wird. Vorteilhafterweise ist dabei ein versehentliches Lösen des Deckelteils vermeidbar, da das Deckelteil in einem großen Schwenkwinkelbereich schwenkbar ist ohne lösbar zu sein. Somit sind von dem Deckelteil abdeckbare Teile des Elektrogerätes inspizierbar bei mit dem Gehäuse verbundenem Deckelteil.

Von Vorteil ist weiter, dass Anzeigemittel, Schalter, Steckverbinder und/oder Gegensteckverbinder am Elektrogerät abdeckbar sind mittels des Deckelteils. Somit ist die Sicherheit des Elektrogerätes verbessert, da eine Fehlbedienung bei geschlossenem Deckelteil verhinderbar ist.

Bei einer vorteilhaften Ausgestaltung weist der Lagerabschnitt einen Einführbereich und einen Drehbereich auf, wobei der Zapfen in der Querrichtung weiter ausgedehnt ist als der Einführbereich in einer zu einer Einführrichtung des Einführbereichs senkrechten Richtung, wobei in der ersten Schwenkwinkelposition die Querrichtung des Zapfens parallel ist zur Einführrichtung. Von Vorteil ist dabei, dass der Zapfen nur in der ersten Schwenkwinkelposition einführbar ist in den Einführbereich des Lagerabschnitts. Somit ist das Deckelteil nur in der ersten Schwenkwinkelposition lösbar von dem Gehäuse. Somit ist ein versehentliches Lösen des Deckelteils vermeidbar.

Der Lagerabschnitt ist in einfacher Art und Weise herstellbar, in dem er in das Gehäuse einfräsbar ist oder in einem Arbeitsgang mit dem Gehäuse als Gussteil, insbesondere Kunststoffspritzgussteil, herstellbar ist.

Bei einer vorteilhaften Ausgestaltung ist der Drehbereich als runde Vertiefung ausgeführt. Von Vorteil ist dabei, dass der Zapfen im Drehbereich drehbar ist. Vorteilhafterweise ist die Drehreibung des Zapfens reduzierbar, so dass der Verschleiß reduzierbar ist. Somit ist die Sicherheit verbessert.

Bei einer vorteilhaften Ausgestaltung ist der Zapfen ebenfalls rund ausgeführt, so dass ein Verkanten des Zapfens in dem Lagerabschnitt vermeidbar ist.

Bei einer vorteilhaften Ausgestaltung erstreckt sich der Drehbereich radial weiter als der Einführbereich in der zur Einführrichtung senkrechten Richtung. Von Vorteil ist dabei, dass der Zapfen nur in der ersten Schwenkwinkelposition durch den Einführbereich bewegbar ist. Im Drehbereich ist der Zapfen beliebig drehbar, so dass das Deckelteil in beliebige Schwenkwinkelpositionen schwenkbar ist.

Bei einer vorteilhaften Ausgestaltung ist der Einführbereich in der Einführrichtung zum Drehbereich hin und zur Umgebung hin offen ausgeführt. Von Vorteil ist dabei, dass der Zapfen von der Umgebung durch den Einführbereich in den Drehbereich einführbar ist, wenn das Deckelteil in der zweiten Schwenkwinkelposition positioniert ist.

Bei einer vorteilhaften Ausgestaltung weist das Deckelteil einen Grundkörper und einen Gelenkabschnitt auf, der aus dem Grundkörper auskragt, wobei der Zapfen an dem Gelenkabschnitt angeordnet ist und beabstandet ist vom Grundkörper, insbesondere wobei Grundkörper, Zapfen und Gelenkabschnitt einstückig ausgeführt sind, insbesondere als Kunststoffspritzgussteil. Von Vorteil ist dabei, dass der verfügbare Schwenkwinkelbereich des Deckelteils vergrößerbar ist mittels des aus dem Grundkörper auskragenden Gelenkabschnitts. Die Schwenkachse des Deckelteils erstreckt sich durch den Gelenkabschnitt hindurch, insbesondere durch den Zapfen hindurch.

Bei einer vorteilhaften Ausgestaltung weist das Gehäuse eine Gelenkaufnahme auf, wobei der Gelenkabschnitt des Deckelteils in der Gelenkaufnahme aufgenommen ist und in axialer Richtung begrenzt ist von der Gelenkaufnahme. Von Vorteil ist dabei, dass der Gelenkabschnitt in der Gelenkaufnahme drehbar ist. Vorteilhafterweise ist die Gelenkaufnahme als Vertiefung in dem Gehäuse ausgeführt. Vorteilhafterweise ist eine Außenseite des Deckelteils bündig und/oder in einer Flucht anordenbar mit einer Außenseite des Gehäuses. Somit ist das Verletzungsrisiko für einen Bediener des Elektrogerätes reduzierbar.

Bei einer vorteilhaften Ausgestaltung ist der Lagerabschnitt als Vertiefung in der Gelenkaufnahme ausgeführt. Von Vorteil ist dabei, dass der Gelenkabschnitt in der Gelenkaufnahme drehbar ist.

Bei einer vorteilhaften Ausgestaltung ist die Gelenkaufnahme als gestufte Vertiefung ausgeführt. Von Vorteil ist dabei, dass die Gelenkaufnahme in einfacher Art und Weise fertigbar ist, beispielsweise mittels Fräsen. Vorteilhafterweise ist die Gelenkaufnahme in einem Arbeitsgang mit einem die Gelenkaufnahme aufweisenden Gehäuseteil fertigbar, beispielsweise als Kunststoffspritzgussteil.

Bei einer vorteilhaften Ausgestaltung weist das Elektrogerät ein Verriegelungsmittel zum Verriegeln des Deckelteils auf, insbesondere wobei das Deckelteil verriegelbar ist am Gehäuse mittels des Verriegelungsmittels. Von Vorteil ist dabei, dass ein unbeabsichtigtes Öffnen des Deckelteils vermeidbar ist. Beim Transport und/oder Einbau des Elektrogerätes sind Steckverbinder und/oder Anzeigemittel am Elektrogerät abdeckbar mittels des Deckelteils und vor Beschädigung schützbar.

Bei einer vorteilhaften Ausgestaltung ist das Verriegelungsmittel am Gehäuse drehbar gelagert um eine Drehachse, wobei das Verriegelungsmittel einen Verbreiterungsabschnitt aufweist, der unrund ausgeführt ist. Von Vorteil ist dabei, dass das Deckelteil mittels des unrunden Verbreiterungsabschnitts am Gehäuse verriegelbar und entriegelbar ist. Das Verriegelungsmittel ist vorteilhafterweise als Schraube ausführbar. Der Schraubenkopf der Schraube ist unrund ausführbar und fungiert als Verbreiterungsabschnitt.

Bei einer vorteilhaften Ausgestaltung weist das Verriegelungsmittel einen, insbesondere exzentrisch zur drehbaren Lagerung des Verriegelungsmittels am Gehäuse, herausragenden Nasenabschnitt auf, der beabstandet ist vom Gehäuse. Von Vorteil ist dabei, dass der Nasenabschnitt zum Verriegeln des Deckelteils als axiales Begrenzungsmittel für einen Vorsprung des Deckelteils wirkt. Der Vorsprung ist dabei zwischen dem Nasenabschnitt und dem Gehäuse anordenbar.

Alternativ ist der Nasenabschnitt in eine Ausnehmung in dem Deckelteil einführbar und ausführbar.

Bei einer vorteilhaften Ausgestaltung ist das Verriegelungsmittel zumindest in eine erste oder eine zweite Position drehbar, wobei das Deckelteil in der ersten Position des Verriegelungsmittels verriegelt ist und wobei das Deckelteil in der zweiten Position des Verriegelungsmittels entriegelt ist. Von Vorteil ist dabei, dass das Deckelteil reversibel am Gehäuse verriegelbar ist. Vorteilhafterweise ist die erste Position gut erkennbar, so dass eine sichere Verriegelung ausführbar ist.

Bei einer vorteilhaften Ausgestaltung ist am Gehäuse und/oder dem Deckelteil zumindest ein Begrenzungsmittel ausgeformt oder verbunden, welches die Drehbewegung des Verriegelungsmittels in beziehungswiese entgegen der Umfangsrichtung begrenzt. Von Vorteil ist dabei, dass das Begrenzungsmittel als Anschlag fungiert für das Verriegelungsmittel. Vorteilhafterweise ist das Verriegelungsmittel in die erste Position drehbar und wird dort von dem Begrenzungsmittel begrenzt. Somit ist die erste Position des Verriegelungsmittels in einfacher Art und Weise blind einstellbar. Eine optische Überprüfung der Position des Verriegelungsmittels ist also verzichtbar.

Bei einer vorteilhaften Ausgestaltung weist das Gehäuse und/oder das Deckelteil ein erstes Begrenzungsmittel auf, wobei das Verriegelungsmittel in der ersten Position von dem ersten Begrenzungsmittel begrenzt ist. Von Vorteil ist dabei, dass mittels des ersten Begrenzungsmittels die erste Position des Verriegelungsmittels anzeigbar beziehungsweise erkennbar ist. Vorteilhafterweise wird das Verriegelungsmittel derart von dem ersten Begrenzungsmittel begrenzt, dass das Deckelteil sicher verriegelt ist.

Bei einer vorteilhaften Ausgestaltung weist das Gehäuse und/oder das Deckelteil ein zweites Begrenzungsmittel auf, wobei das Verriegelungsmittel in der zweiten Position von dem zweiten Begrenzungsmittel begrenzt ist. Von Vorteil ist dabei, dass mittels des zweiten Begrenzungsmittels die zweite Position des Verriegelungsmittels anzeigbar beziehungsweise erkennbar ist. Vorteilhafterweise wird das Verriegelungsmittel derart von dem zweiten Begrenzungsmittel begrenzt, dass das Deckelteil sicher entriegelt ist.

Bei einer vorteilhaften Ausgestaltung sind das erste und zweite Begrenzungsmittel einstückig ausgeführt. Von Vorteil ist dabei, dass die Begrenzungsmittel in einfacher Art und Weise herstellbar sind.

Bei einer vorteilhaften Ausgestaltung ist das Verriegelungsmittel in einer ersten Drehrichtung in die erste Position verdrehbar und in einer zweiten Drehrichtung in die zweite Position verdrehbar, wobei die erste und zweite Drehrichtung einander entgegengesetzt sind. Von Vorteil ist dabei, dass mittels der Drehrichtung und des Begrenzungsmittels eindeutig die Position des Verriegelungsmittels anzeigbar ist.

Bei einer vorteilhaften Ausgestaltung weist das Deckelteil einen Vorsprung auf, wobei der Vorsprung in der ersten Position des Verriegelungsmittels zumindest teilweise zwischen dem Gehäuse und dem Nasenabschnitt angeordnet ist. Von Vorteil ist dabei, dass der Vorsprung zwischen dem Gehäuse und dem Nasenabschnitt in Schwenkrichtung des Deckelteils begrenzbar ist, somit ist das Deckelteil sicher verriegelbar.

Bei einer vorteilhaften Ausgestaltung überdeckt in der ersten Position des Verriegelungsmittels die axiale Projektion des Nasenabschnitts relativ zur Drehachse des Verriegelungsmittels, die axiale Projektion des Vorsprungs relativ zur Drehachse des Verriegelungsmittels zumindest teilweise. Von Vorteil ist dabei, dass der Vorsprung zwischen dem Gehäuse und dem Nasenabschnitt axial begrenzbar ist, somit ist das Deckelteil sicher verriegelbar.

Vorteilhafterweise ist die Schwenkrichtung des Deckelteils in der zweiten Schwenkwinkelposition parallel zur Drehachse des Verriegelungsmittels.

Bei einer vorteilhaften Ausgestaltung ist der Vorsprung in der zweiten Position des Verriegelungsmittels von dem Nasenabschnitt in radialer Richtung relativ zur Drehachse des Verriegelungsmittels beabstandet. Von Vorteil ist dabei, dass das Deckelteil in der zweiten Position des Verriegelungsmittels schwenkbar ist, insbesondere nicht blockiert ist.

Bei einer vorteilhaften Ausgestaltung weist das Deckelteil eine erste Ausnehmung auf, die mit einem Abdeckteil verschließbar ist, wobei das Deckelteil mit dem Abdeckteil lösbar verbunden ist, insbesondere klipsverbunden, wobei das Abdeckteil in der zweiten Schwenkwinkelposition das Verriegelungsmittel abdeckt. Von Vorteil ist dabei, dass eine unbeabsichtigte Betätigung des Verriegelungsmittels verhinderbar ist. Somit ist ein unbeabsichtigtes Öffnen des Deckelteils verhinderbar. Die Sicherheit des Elektrogeräts ist verbessert.

Bei einer vorteilhaften Ausgestaltung deckt das Abdeckteil in der zweiten Schwenkwinkelposition ein Steckverbinderteil ab. Von Vorteil ist dabei, dass das Steckverbinderteil vor unbeabsichtigtem Kontakt schützbar ist. So sind beispielsweise Spannungsüberschläge durch elektrostatische Aufladung bei elektrischen Steckverbinderteilen vermeidbar.

Bei einer vorteilhaften Ausgestaltung weist das Gehäuse ein Einschubführungsteil auf, in das ein Typenschild einschiebbar ist, wobei das Deckelteil eine Nut aufweist, wobei in der zweiten Schwenkwinkelposition das Typenschild in der Nut angeordnet, insbesondere aufgenommen, ist. Von Vorteil ist dabei, dass das Deckelteil zusätzlich verriegelbar ist mittels des eingeschobenen Typenschildes, insbesondere als zusätzliche Verriegelung zu dem Verriegelungsmittel. Vorteilhafterweise ist die Nut passgenau für das Typenschild ausführbar, so dass eine formschlüssige Verbindung des Typenschildes mit dem Deckelteil herstellbar ist.

Bei einer vorteilhaften Ausgestaltung ist ein Gehäuseteil des Gehäuses mit dem Einschubführungsteil verbunden, wobei das Gehäuseteil als Metallteil ausgeführt ist und/oder das Typenschild und/oder das Einschubführungsteil als Kunststoffteil ausgeführt sind. Von Vorteil ist dabei, dass das Typenschild gleitlagerbar ist in dem Einschubführungsteil. Vorteilhafterweise weisen das Typenschild und das Einschubführungsteil ähnliche mechanische Eigenschaften auf, so dass beim Einschieben des Typenschildes in das Einschubführungsteil beide Kunststoffteile vorwiegend elastisch verformbar sind.

Bei einer vorteilhaften Ausgestaltung ist ein Bedienteil lösbar mit dem Gehäuse verbunden, insbesondere klipsverbunden, wobei das Deckelteil eine zweite Ausnehmung aufweist, durch die das Bedienteil hindurchbedienbar ist, wobei das Deckelteil das Bedienteil am Gehäuse sichert, insbesondere hält. Von Vorteil ist dabei, dass das Bedienteil in einfacher Art und Weise austauschbar ist. Mittels des Deckelteils ist ein unbeabsichtigtes Lösen des Bedienteils verhinderbar.

Bei einer vorteilhaften Ausgestaltung weist das Deckelteil eine dritte Ausnehmung auf, wobei am Elektrogerät ein weiteres Steckverbinderteil angeordnet ist, das durch die dritte Ausnehmung hindurch zugänglich ist, insbesondere für ein Gegensteckverbinderteil, insbesondere so dass das Gegensteckverbinderteil zur Verbindung mit dem weiteren Steckverbinderteil durch die dritte Ausnehmung hindurch führbar ist und steckverbindbar ist mit dem Steckverbinderteil, insbesondere in der zweiten Schwenkwinkelposition. Von Vorteil ist dabei, dass eine Steckverbindung des Steckverbinders mit dem Gegensteckverbinder auch bei geschlossenem Deckelteil in einfacher Art und Weise herstellbar ist.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von Abbildungen näher erläutert:
In der Figur 1 ist ein erfindungsgemäßes Elektrogerät, insbesondere ein Umrichter 1, in einer ersten Ausführungsform, aufweisend ein geschlossenes Deckelteil 4, in Schrägansicht gezeichnet.
Figur 2 zeigt das erfindungsgemäße Elektrogerät in der ersten Ausführungsform in Schrägansicht, wobei das Deckelteil 4 aufgeklappt ist.
In Figur 3 ist eine Detailansicht des Deckelteils 4 der ersten Ausführungsform gezeigt.
Figur 4 zeigt eine Detailansicht eines entriegelten Verriegelungsmittels 23 für das Deckelteil 4 der ersten Ausführungsform in Schrägansicht.
Figur 5 zeigt eine Detailansicht eines verriegelten Verriegelungsmittels 23 für das Deckelteil 4 der ersten Ausführungsform in Schrägansicht.
In Figur 6 ist eine zweite erfindungsgemäße Ausführungsform des Elektrogerätes mit einem geöffneten Deckelteil 63 dargestellt.
Figur 7 zeigt eine Detailansicht des Deckelteils 63 der zweiten Ausführungsform.
Figur 8 zeigt eine weitere Detailansicht des Deckelteils 63 der zweiten Ausführungsform, wobei das Deckelteil 63 geschlossen ist.
Figur 9 zeigt eine Detailansicht des Deckelteils 63 der zweiten Ausführungsform, wobei das Deckelteil 63 geöffnet ist.
In den Figuren 10 bis 14 ist eine dritte Ausführungsform des erfindungsgemäßen Elektrogerätes gezeigt.

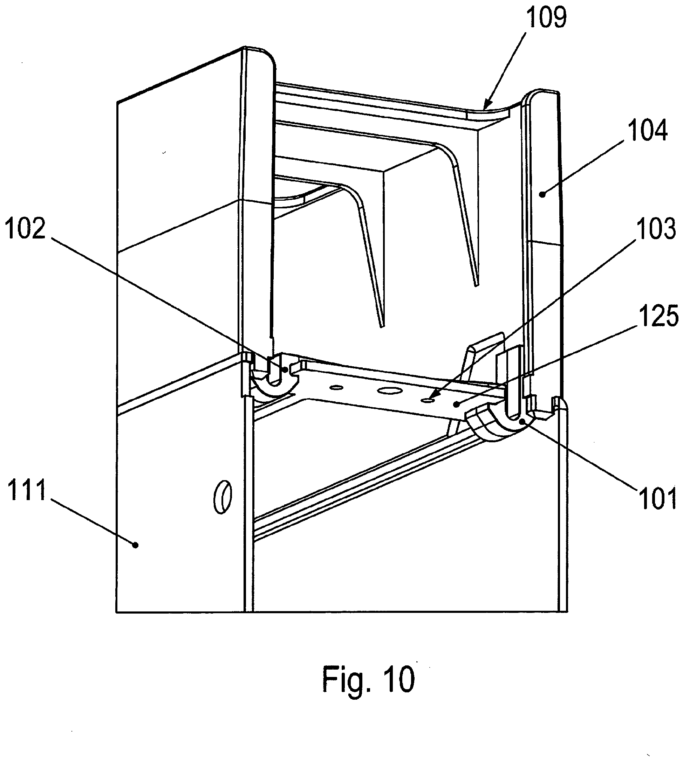

Figur 10 zeigt eine Schrägansicht eines Deckelteils 104 der dritten Ausführungsform, das mittels zumindest eines Verriegelungsmittels (101, 102) mit einem Gehäuseteil 125 verbunden ist.

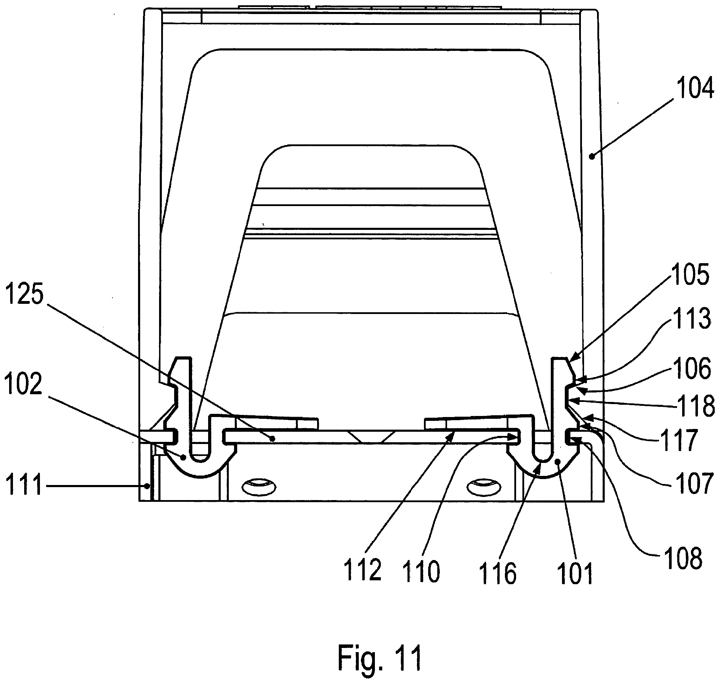

In Figur 11 ist eine Schnittansicht des Elektrogerätes in der dritten Ausführungsform in Draufsicht gezeichnet.

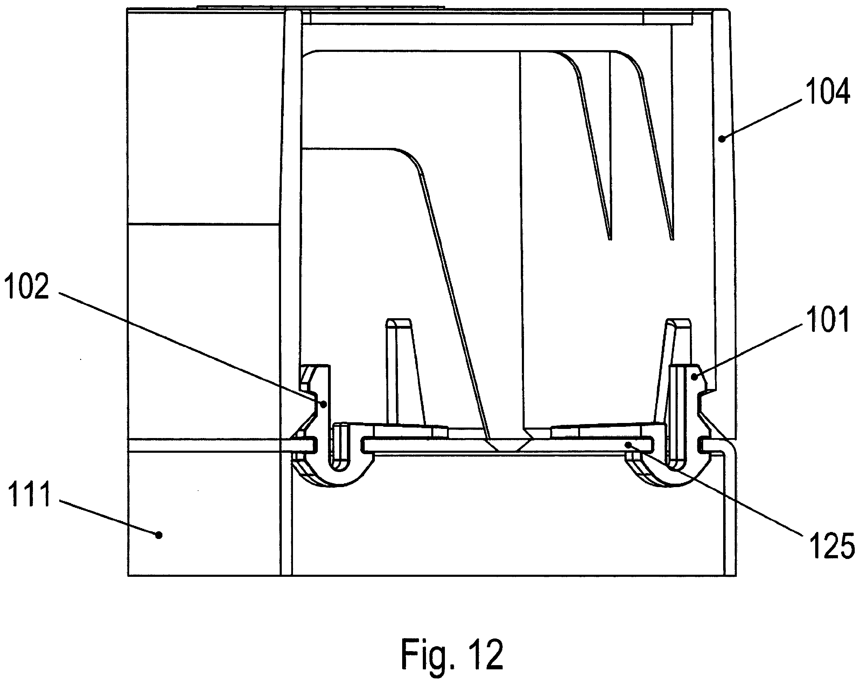

Figur 12 zeigt die Schnittansicht des Elektrogerätes in der dritten Ausführungsform in Schrägansicht.

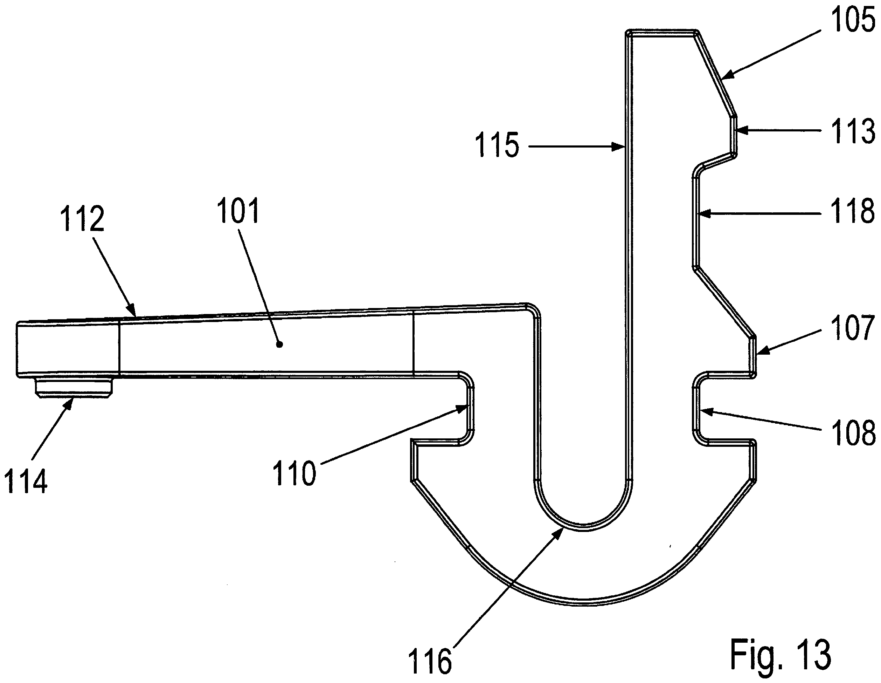

In Figur 13 ist eine Detailansicht des Verriegelungsmittels der dritten Ausführungsform dargestellt.

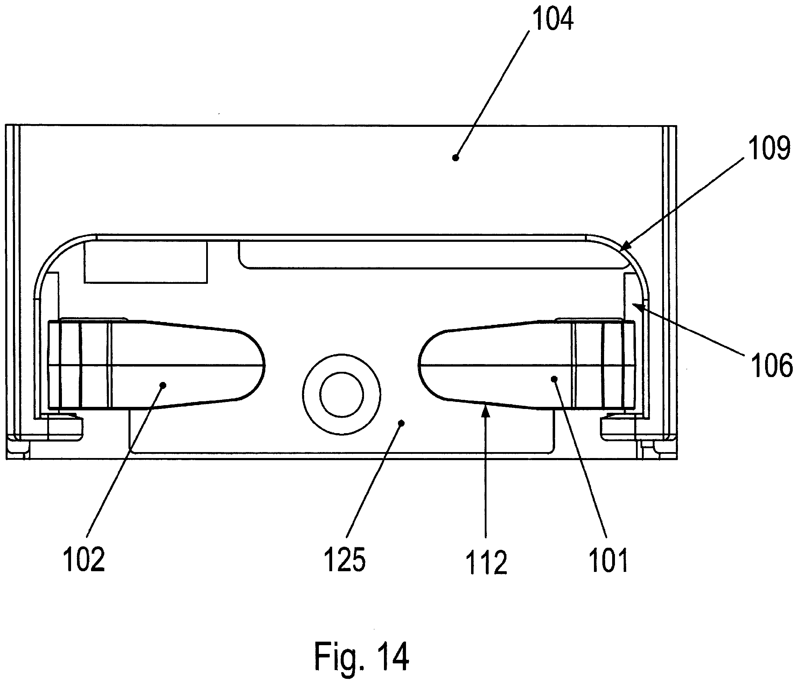

Figur 14 zeigt eine weitere Draufsicht auf das Elektrogerät in der dritten Ausführungsform.

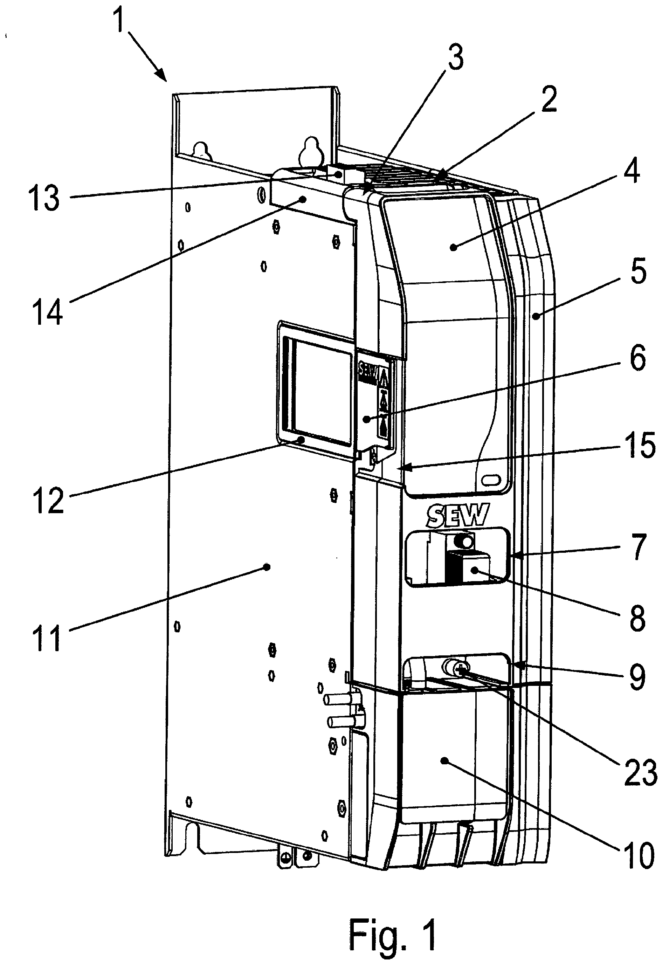

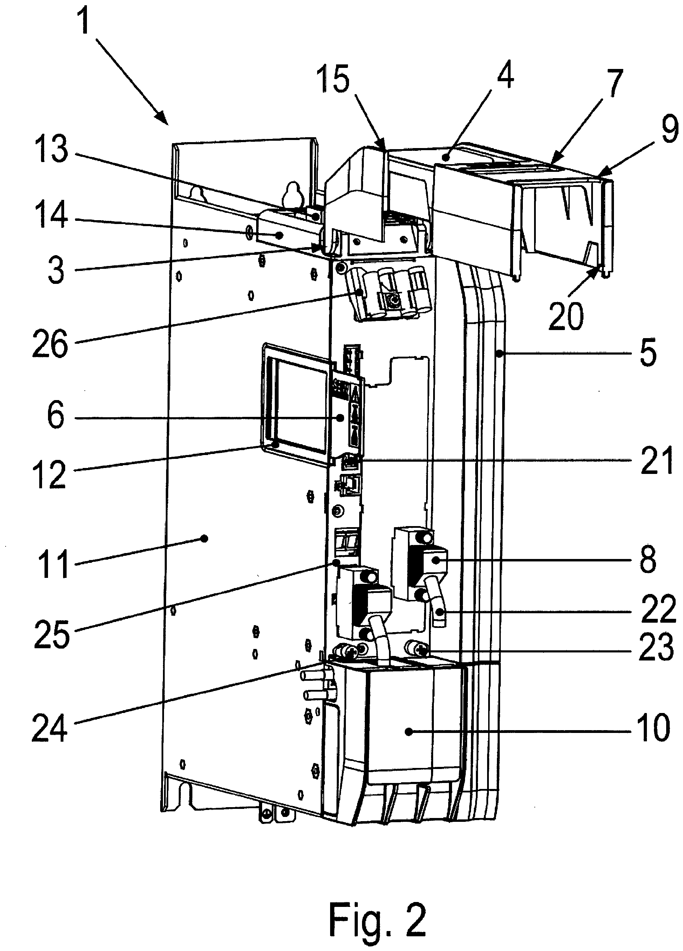

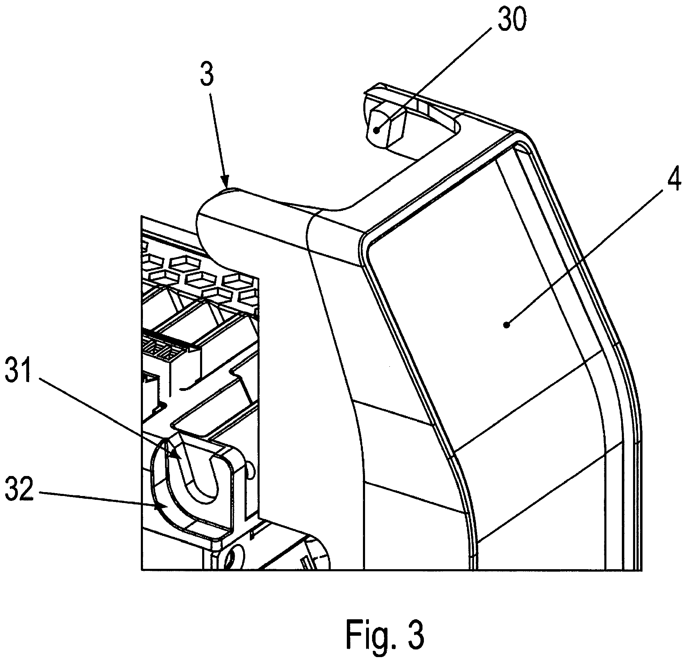

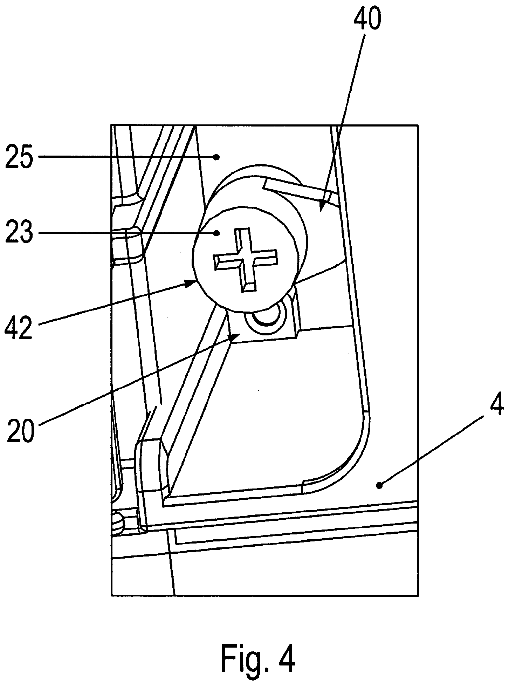

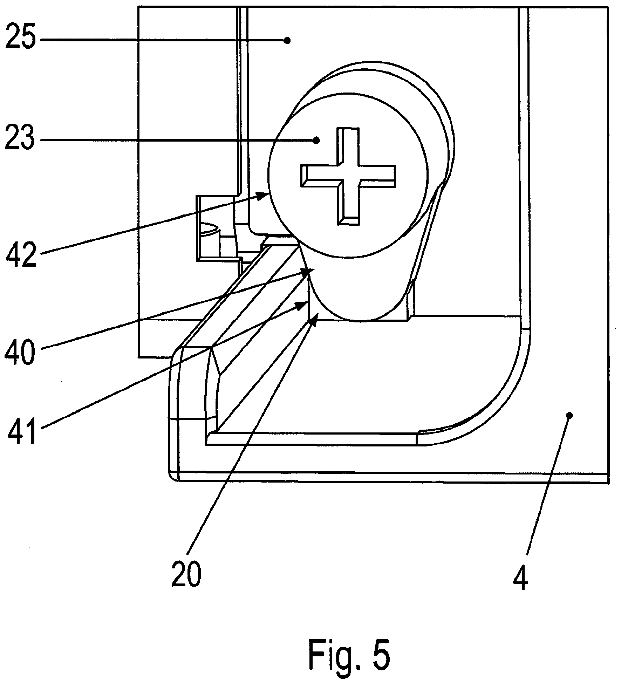

Das in den Figuren 1 bis 5 dargestellte erste Ausführungsbeispiel des Umrichters 1 weist das Deckelteil 4 und ein zumindest ein Gehäuseteil 14 aufweisendes Gehäuse auf, mit dem das Deckelteil 4 schwenkbar und lösbar verbunden ist. Dazu weist das Deckelteil 4 einen Gelenkabschnitt 3 auf. Der Gelenkabschnitt 3 weist einen Zapfen 30 auf, der aus dem Deckelteil 4 auskragt. Dabei fungiert der Zapfen 30 als Gelenkkopf für das Deckelteil 4.

Der Zapfen 30 ist in Querrichtung zur Schwenkrichtung länglich ausgeführt. Vorzugsweise erstreckt sich der Zapfen 30 in einer Einführrichtung des Zapfens 30 weiter als in einer Querrichtung zur Einführrichtung.

Vorzugsweise ist der Zapfen 30 zylindrisch ausgeführt. Vorzugsweise weist die Grundfläche des Zapfens 30 zwei gerade Umfangsabschnitte auf, die parallel ausgeführt sind.

Unter parallel wird hierbei ein Winkelbereich zwischen zwei Geraden verstanden, der kleiner als 40° ist, vorzugsweise kleiner als 30°, besonders bevorzugt kleiner als 20°.

Vorzugsweise ist das Gehäuse mehrteilig ausgeführt und weist Gehäuseteile aus metallischem Material, beispielsweise aus Aluminium, und/oder aus Kunststoff auf, insbesondere Kunststoffspritzgussteile.

Das Gehäuseteil 14 weist einen Lagerabschnitt 31 auf, der in einer Gelenkaufnahme 32 für den Gelenkabschnitt 3 des Deckelteils 4 angeordnet ist. Die Gelenkaufnahme 32 ist als eine mehrstufige Vertiefung ausgeführt. Dabei bildet der Lagerabschnitt 31 eine Stufe der mehrstufigen Vertiefung und erstreckt sich am weitesten in das Gehäuseteil 14 hinein.

Der Zapfen 30 ist in dem Lagerabschnitt 31 gelagert. Vorzugsweise weist der Lagerabschnitt 31 in Querrichtung zur Schwenkrichtung des Deckelteils 4 eine Öffnung auf, durch die der Zapfen 30 in den Lagerabschnitt 31 einführbar ist.

Der Lagerabschnitt 31 weist einen Einführbereich und einen Drehbereich auf. Der Einführbereich erstreckt sich in der Einführrichtung von der Umgebung zum Drehbereich. Dabei ist der Einführbereich zur Umgebung und zum Drehbereich hin offen ausgeführt. Der Drehbereich ist als runde Vertiefung ausgeführt, wobei der Radius des Drehbereichs größer ist als der Einführbereich in Querrichtung zur Einführrichtung.

Vorteilhafterweise weist das Deckelteil 4 zwei Zapfen 30 auf, die eine gemeinsame Schwenkachse aufweisen. Die Zapfen 30 erstrecken sich von einem jeweiligen Gelenkabschnitt 3 des Deckelteils 4 und sind einander gegenüberliegend angeordnet. Das Gehäuseteil 14 ist also axial zwischen den Gelenkabschnitten 3 angeordnet. Die Gelenkaufnahmen 32 für den jeweiligen Zapfen 30 begrenzen die Gelenkabschnitte 3 in axialer Richtung.

Die axiale Richtung wird dabei definiert mittels der Schwenkachse beziehungsweise Drehachse des Deckelteils 4.

An dem Gehäuseteil 14 ist ein Steckverbinderteil 13 angeordnet. Das Gehäuseteil 14 weist Ausnehmungen 2, insbesondere Lüftungsschlitze zur Kühlung des Umrichters 1 auf.

Das Gehäuse des Umrichters 1 weist ein weiteres Gehäuseteil 25 auf. Das Deckelteil 4 ist mit dem weiteren Gehäuseteil 25 lösbar verbindbar mittels zumindest eines Verriegelungsmittels 23, vorzugsweise weist das Elektrogerät zwei Verriegelungsmittel (23, 24) auf.

Vorzugsweise ist das Verriegelungsmittel 23 an einem dem Gelenkabschnitt 3 gegenüberliegenden Endbereich des Deckelteils 4 am Deckelteil 4 verriegelbar.

Das Gehäuseteil 25 ist zumindest teilweise abdeckbar mittels des Deckelteils 4.

Vorzugsweise sind die Verriegelungsmittel (23, 24) jeweils als Schraubteil ausgeführt und weisen jeweils einen Nasenabschnitt 40 auf. Dabei kragt der jeweilige Nasenabschnitt 40 von einem jeweiligen als Verbreiterungsabschnitt 42 fungierenden Schraubenkopf des jeweiligen Verriegelungsmittels (23, 24) aus. Ein jeweiliger Schraubenkopf des jeweiligen Schraubteils ist unrund, insbesondere exzentrisch zur Schraubenachse, ausgeführt.

Zur Verriegelung des Deckelteils 4 am Gehäuseteil 25 weist das Deckelteil 4 zumindest einen Vorsprung 20 auf, der von dem Deckelteil 4 auskragt. Im verriegelten Zustand ist jeweils ein Vorsprung 20 zumindest teilweise zwischen dem jeweiligen Nasenabschnitt 40 und dem Gehäuseteil 25 angeordnet. Der Nasenabschnitt 40 begrenzt den Vorsprung 20, so dass das Deckelteil 4 am Gehäuseteil 25 verriegelt ist.

Vorzugsweise ist das jeweilige Verriegelungsmittel (23, 24) jeweils drehbar an dem Gehäuseteil 25 angeordnet. Dabei ist das Deckelteil 4 mittels Drehen des/der Verriegelungsmittel (23, 24) verriegelbar und/oder entriegelbar. Wird das jeweilige Verriegelungsmittel (23, 24) bei geschlossenem Deckelteil 4 gedreht, so greift der jeweilige Nasenabschnitt 40 über den Vorsprung 20 und verriegelt das Deckelteil 4. Vorzugsweise weist das Deckelteil 4 ein Begrenzungsmittel 41, aufweisend einen jeweiligen ersten Anschlag für den jeweiligen Nasenabschnitt 40, auf, so dass das jeweilige Verriegelungsmittel (23, 24) in einer ersten Drehrichtung bis in eine erste Position verdrehbar ist, in der das Deckelteil 4 verriegelt ist. Zum Entriegeln des Deckelteils 4 wird das jeweilige Verriegelungsmittel (23, 24) in eine zweite Drehrichtung gedreht, die der ersten Drehrichtung entgegengerichtet ist.

Vorzugsweise weist das Deckelteil 4 einen zweiten Anschlag für das jeweilige Deckelteil 4 auf, so dass das jeweilige Verriegelungsmittel (23, 24) in der zweiten Drehrichtung bis in eine zweite Position verdrehbar ist, in der das Deckelteil 4 unverriegelt ist. Vorzugsweise sind der erste und zweite Anschlag als zwei Seiten des Begrenzungsmittels 41 ausgeführt. Alternativ fungiert der Vorsprung 20 am Deckelteil 4 als Begrenzungsmittel 41.

In dem Gehäuseteil 25 ist zumindest ein weiteres Steckverbinderteil 21 zur Verbindung mit einem Gegensteckverbinderteil angeordnet. Beispielsweise ist ein Datenbus, eine Drehspannungsversorgung, ein 24V-Anschluss, ein Motorkabel oder ein Sensorkabel an den Umrichter 1 anschließbar.

An dem Gehäuseteil 25 ist zumindest eine Kabelführung 26 angeordnet. Vorteilhafterweise sind die Kabelführung 26 und das Steckverbinderteil 21 abdeckbar mittels des Deckelteils 4.

Der Umrichter 1 weist ein Abdeckteil 5 auf, das benachbart zu dem Deckelteil 4 angeordnet ist und fest mit dem Gehäuse verbunden ist. Vorzugsweise sind das Abdeckteil 5 und das Deckelteil 4 aus Kunststoff ausgeführt.

Der Umrichter 1 weist ein Einschubführungsteil 12 für ein Typenschild 6 auf. Auf dem Typenschild 6 sind technische Informationen und Warnhinweise aufgebracht. Das Typenschild 6 ist in das Einschubführungsteil 12 einschiebbar und vom Benutzer entnehmbar, so dass die technischen Informationen und Warnhinweise lesbar sind. Vorteilhafterweise erstreckt sich das Einschubführungsteil 12 in einer von einem Gehäuseteil 11 des Gehäuses aufgespannten Ebene.

Das Typenschild 6 und das Einschubführungsteil 12 sind als Kunststoffteile, insbesondere Kunststoffspritzgussteile ausgeführt. Vorzugsweise ist das Typenschild 6 am Einschubführungsteil 12 gleitgelagert. Das Gehäuseteil 11 ist als Metallteil ausgeführt. Beispielsweise ist das Typenschild 6 als Speicherkarte, SD-Karte oder Chipkarte ausführbar und weist computerlesbare technische Informationen auf, die mittels eines mit einem Computer verbundenen Lesegeräts lesbar sind.

Das Deckelteil 4 weist eine Nut 15 auf. Bei geschlossenem Deckelteil 4 ist das Typenschild 6 von der Nut 15 geführt in das Einschubführungsteil 12 einschiebbar und/oder in der Nut 15 aufgenommen.

Das Deckelteil 4 weist zumindest eine Ausnehmung 9 auf, durch welche ein Werkzeug, insbesondere ein Schraubendreher, zur Bedienung der Verriegelungsmittel (23, 24) hindurchführbar ist.

Mit dem Umrichter 1 ist ein Gegensteckverbinderteil 8 verbindbar. Vorzugsweise ist das Gegensteckverbinderteil 8 mittels des Deckelteils 4 teilweise einhausbar. Vorzugsweise weist das Deckelteil 4 eine weitere Ausnehmung 7 auf, durch die ein in den Figuren nicht dargestelltes Anzeigemittel des Umrichters 1 sichtbar ist, insbesondere ein Display oder eine Siebensegmentanzeige.

Der Umrichter 1 weist eine Kabelführung 10 auf, mittels der ein mit dem Gegensteckverbinderteil 8 verbundenes Kabel 22 geführt ist.

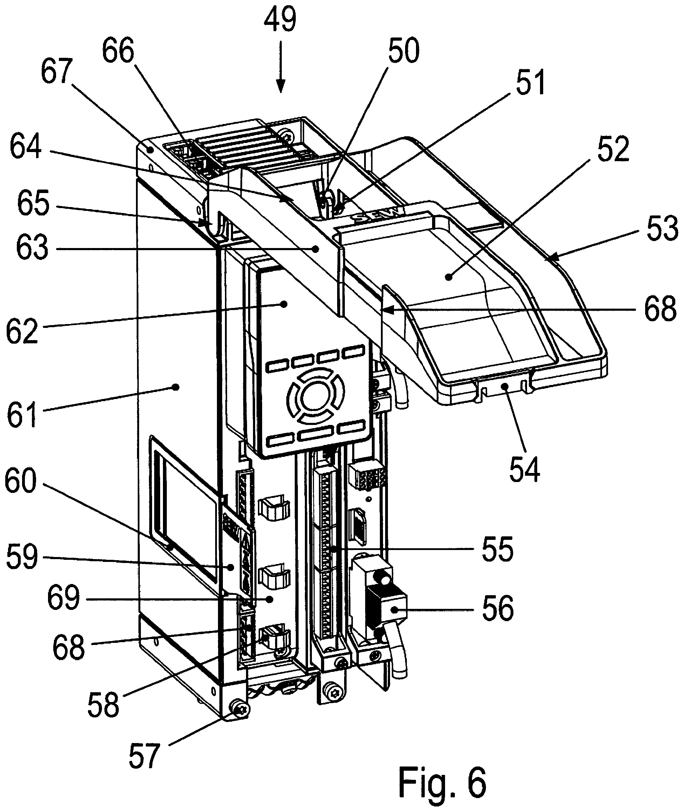

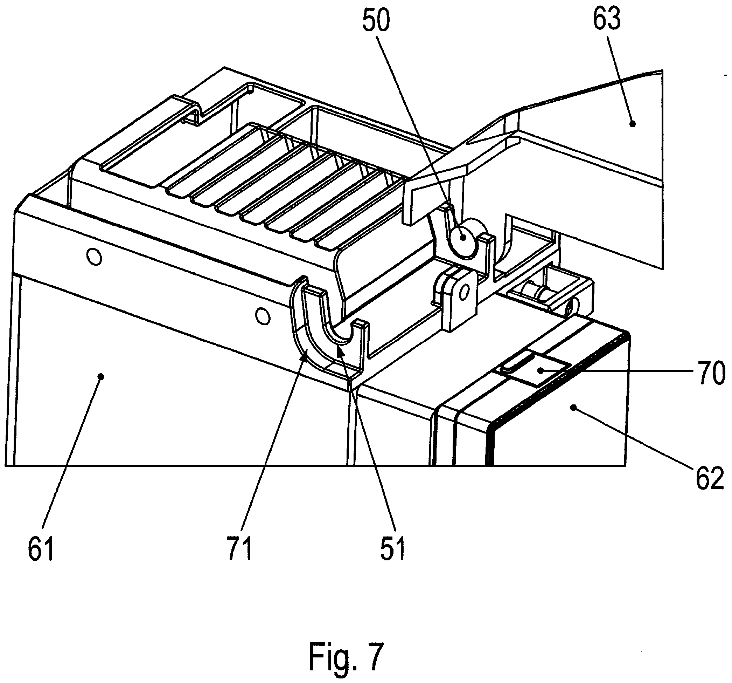

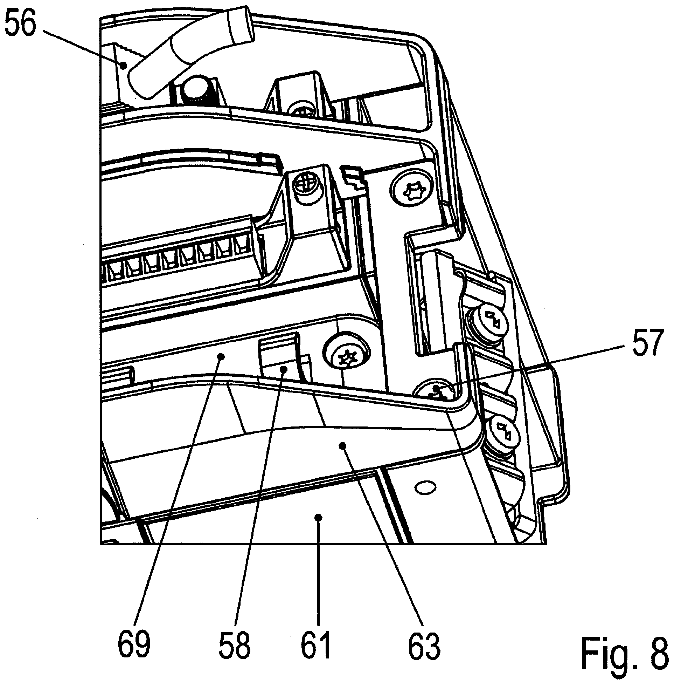

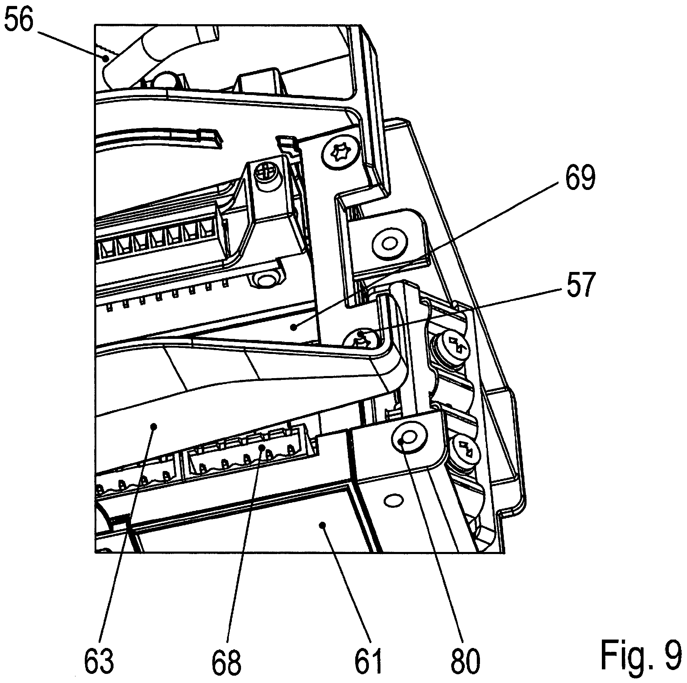

Ein in den Figuren 6 bis 9 dargestelltes zweites Ausführungsbeispiel des Elektrogerätes, insbesondere ein Umrichter 49, weist ein Deckelteil 63 und ein zumindest ein Gehäuseteil 67 aufweisendes Gehäuse auf. Das Deckelteil 63 ist schwenkbar an dem Gehäuseteil 67 angeordnet.

Das Deckelteil 63 weist einen Gelenkabschnitt 65 auf, an dem ein Zapfen 50 angeordnet ist. Vorzugsweise fungiert der Zapfen 50 als Gelenkkopf. An dem Gehäuseteil 67 ist eine Gelenkaufnahme 71 ausgeführt, die einen Lagerabschnitt 51 aufweist. Der Zapfen 50 ist in dem Lagerabschnitt 51 gelagert.

Der Zapfen 50 ist kreiszylindrisch ausgeführt und weist eine kreisförmige Grundfläche auf. Der Lagerabschnitt 51 weist in Querrichtung zur Schwenkachse des Deckelteils 63 eine Öffnung auf, vorzugsweise ist der Lagerabschnitt 51 U-förmig ausgeführt. Durch die Öffnung ist der Zapfen 50 in den Lagerabschnitt 51 einführbar.

Vorzugsweise ist das Gehäuse mehrteilig ausgeführt und weist Gehäuseteile (61, 67) aus Kunststoff und/oder aus metallischem Material auf, beispielsweise Aluminium. Vorzugsweise ist das Deckelteil 63 ein Kunststoffteil, vorzugsweise ein Kunststoffspritzgussteil.

Das Deckelteil 63 ist lösbar mit dem Gehäuseteil 67 verbindbar.

Vorzugsweise weist das Deckelteil 63 zwei parallel zur Schwenkachse angeordnete Zapfen 50 auf, die in zwei entsprechenden Lagerabschnitten 51 des Gehäuseteils 67 anordenbar sind.

Das Deckelteil 63 ist mit einem weiteren Gehäuseteil 61 des Gehäuses lösbar verbindbar mittels eines Verbindungsmittels 57, insbesondere eines Schraubteils. Dazu ist das Verbindungsmittel 57 teilweise durch eine Ausnehmung in dem Deckelteil 63 geführt und mit dem Gehäuseteil 61 schraubverbunden. Das Gehäuseteil 61 weist ein weiteres Verbindungsmittel 80, insbesondere Gewindeteil, auf, mit dem das Verbindungsmittel 57 verbunden ist, insbesondere schraubverbunden.

Das Deckelteil 63 weist eine Ausnehmung auf, die mittels eines Abdeckteils 52 verschließbar ist. Das Abdeckteil 52 verdeckt das Verbindungsmittel 57, insbesondere Schraubteil. Das Abdeckteil 52 ist lösbar mit dem Deckelteil 63 verbunden, vorzugsweise klipsverbunden, insbesondere mittels eines Verbindungsmittels 54, insbesondere Klipsverbinder, verbunden.

Der Umrichter 49 weist zumindest ein Steckverbinderteil 68 auf, insbesondere zur Verbindung mit einem Datenübertragungskabel. Das Steckverbinderteil 68 ist an einem Gehäuseteil 69 des Gehäuses angeordnet, das zumindest teilweise mittels des Abdeckteils 52 abdeckbar ist.

Die Steckverbinderteile (13, 21, 55, 56) sind vorzugweise als Buchsen ausgeführt.

An dem Gehäuseteil 69 ist zumindest eine Kabelführung 58 angeordnet.

Der Umrichter 49 weist ein Bedienteil 62 auf. Vorzugsweise ist das Bedienteil lösbar mit einem Gehäuseteil 59 des Umrichters 49 verbunden, vorzugsweise klipsverbunden, insbesondere mittels eines Verbindungsmittels 70, insbesondere Klipsverbinders. Das Bedienteil 62 weist ein Anzeigemittel, insbesondere Display, und Bedienelemente auf.

Vorzugsweise weist das Deckelteil 63 eine Ausnehmung 64 auf, durch die das Bedienteil 62 zumindest teilweise in das Deckelteil 63 hineinragt und/oder durch das Deckelteil 63 hindurchragt. Das Bedienteil 62 ist durch die Ausnehmung 64 hindurch bedienbar.

Das Deckelteil 63 weist eine weitere Ausnehmung 53 auf, vorzugsweise erstreckt sich die Ausnehmung 53 über die gesamte Länge des Deckelteils 63. Durch die Ausnehmung 53 ist zumindest ein Gegensteckverbinderteil 56 zur Verbindung mit einem Steckverbinderteil 55 des Umrichters 49 hindurchführbar.

Der Umrichter 49 weist ein Einschubführungsteil 60 für ein Typenschild 59 auf. Auf dem Typenschild 59 sind technische Informationen und Warnhinweise aufgebracht. Das Typenschild 59 ist in das Einschubführungsteil 60 einschiebbar und vom Benutzer entnehmbar, so dass die technischen Informationen und Warnhinweise lesbar sind. Vorteilhafterweise erstreckt sich das Einschubführungsteil 60 in einer von dem Gehäuseteil 61 aufgespannten Ebene.

Das Deckelteil 63 weist eine Nut 68 auf. Bei geschlossenem Deckelteil 63 ist das Typenschild 59 von der Nut 68 geführt in das Einschubführungsteil 60 einschiebbar und/oder in der Nut 68 aufgenommen. Somit ist das Deckelteil 63 verriegelbar mittels des Typenschildes 59.

Das Gehäuseteil 67 weist zumindest ein Steckverbinderteil 66 auf, insbesondere zur Verbindung mit einem Datenbus.

Ein in den Figuren 10 bis 14 dargestelltes drittes Ausführungsbeispiel des Elektrogerätes weist ein Gehäuse mit zumindest einem Gehäuseteil (111, 125) und ein Deckelteil 104 auf. Das Deckelteil 104 ist am Gehäuse schwenkbar gelagert und mittels eines Verriegelungsmittels 101 lösbar mit dem Gehäuse verbunden, vorzugsweise klipsverbunden.

Das Verriegelungsmittel 101 ist in eine schlitzförmige Ausnehmung in dem Gehäuseteil 125 einschiebbar. Dazu weist das Verriegelungsmittel 101 zwei einander gegenüberliegende Nuten, insbesondere Führungsnuten (108, 110), auf. Die Führungsnuten (108, 110) spannen eine gemeinsame Ebene auf. Vorzugsweise erstreckt sich das Gehäuseteil 125 zumindest teilweise in dieser Ebene.

Das Verriegelungsmittel 101 weist einen Verbindungsabschnitt 115 und einen Befestigungsabschnitt 112 auf, die sich jeweils in einer Querrichtung zu einer Erstreckungsrichtung der Führungsnuten (108, 110) erstrecken. Vorzugsweise sind der Verbindungsabschnitt 115 und der Befestigungsabschnitt 112 senkrecht zueinander angeordnet. Vorzugsweise erstreckt sich der Befestigungsabschnitt 12 parallel zu dem Gehäuseteil 125.

Der Verbindungsabschnitt 115 und der Befestigungsabschnitt 112 sind elastisch auslenkbar zueinander ausgeführt. Dazu weist das Verriegelungsmittel 101 eine schlitzförmige Aussparung 116 auf, die sich parallel zur Erstreckungsrichtung der Führungsnuten (108, 110) erstreckt. Vorzugsweise ist die Aussparung 116 zwischen den Führungsnuten (108, 110) angeordnet. Vorzugsweise erstreckt sich die Aussparung 116 durch die gemeinsame Ebene der Führungsnuten (108, 110) hindurch. Somit ist also der Abstand zwischen den Führungsnuten (108, 110) elastisch veränderlich.

Der Befestigungsabschnitt 112 weist einen dem Gehäuseteil 125 zugewandten Vorsprung 114 auf. Das Gehäuseteil 125 weist eine Ausnehmung 109 auf, die vorzugsweise als Bohrung ausgeführt ist. Der Vorsprung 114 ist in die Ausnehmung 109 einführbar, insbesondere einklipsbar. Dabei begrenzt die Verbindung des Vorsprungs 114 mit der Ausnehmung 109 die Beweglichkeit des Verriegelungsmittels 101 zumindest in der Erstreckungsrichtung der Führungsnuten (108, 110).

Der Befestigungsabschnitt 112 ist in einer Querrichtung zur Erstreckungsrichtung der Führungsnuten (108, 110) elastisch verformbar ausgeführt. Dabei ist der Vorsprung 114 beabstandet von den Führungsnuten (108, 110) angeordnet. Zwischen dem Vorsprung 114 und den Führungsnuten (108, 110) ist ein elastischer Bereich angeordnet.

Der Befestigungsabschnitt 112 erstreckt sich beim montierten Verriegelungsmittel 101 parallel zu dem Gehäuseteil 125. Die Führungsnuten (108, 110) weisen entgegengesetzt gerichtete Nutöffnungen auf. Das Gehäuseteil 125 ragt in die Führungsnuten (108, 110) hinein und begrenzt das Verriegelungsmittel 101 an den Führungsnuten (108, 110) in Querrichtung zur Erstreckungsrichtung der Führungsnuten (108, 110), insbesondere in allen Querrichtungen zur Erstreckungsrichtung der Führungsnuten (108, 110). Der von den Führungsnuten (108, 110) abgewandte Endbereich des Befestigungsabschnitts 112 ist also elastisch auslenkbar relativ zu dem den Führungsnuten (108, 110) zugewandten Endbereich des Befestigungsabschnitts 112.

Zur Verbindung des Verriegelungsmittels 101 mit dem Gehäuseteil 125 wird das Verriegelungsmittel 101 in die schlitzförmige Ausnehmung in dem Gehäuseteil 125 eingeschoben. Dabei verformt sich der Befestigungsabschnitt 112 elastisch, so dass der Befestigungsabschnitt 112 das Gehäuseteil 125 nur mit dem Vorsprung 114 berührt. Sobald der Vorsprung 114 beim Einschieben die Ausnehmung 109 erreicht, federt der Befestigungsabschnitt 112 in seine ursprüngliche Form zurück. Der Vorsprung 114 ist formschlüssig und kraftschlüssig mit der Ausnehmung 109 verbunden. Der Befestigungsabschnitt 112 berührt das Gehäuseteil 125 auf seiner ganzen Länge, insbesondere der Länge quer zur Erstreckungsrichtung der Führungsnuten (108, 110). Vorteilhafterweise ist der Vorsprung 114 als abgerundeter Zylinder ausgeführt, der passgenau in die als Bohrung ausgeführte Ausnehmung 109 einführbar ist.

Das Verriegelungsmittel 108 weist einen ersten Nasenabschnitt 113 auf, der eine Fase 105, insbesondere Einfädelfase für das Deckelteil 104, aufweist. Das Deckelteil weist einen zweiten Nasenabschnitt 106 auf, der eine Fase 117, insbesondere Einfädelfase für das Verriegelungsmittel 101, aufweist. Vorzugsweise sind der erste und zweite Nasenabschnitt (113, 106) einander zugewandt angeordnet.

Bei geschlossenem Deckelteil 104 berühren sich der erste und zweite Nasenabschnitt (113, 106). Dazu weisen der erste und zweite Nasenabschnitt (113, 106) jeweils einen Berührbereich auf. Vorzugsweise schließt der jeweilige Berührbereich mit einer Einklipsrichtung des Deckelteils 104 einen Winkel ein der kleiner als 90° ist aber größer als der Winkel zwischen der jeweiligen Einfädelnut (105, 117) und der Einklipsrichtung.

Vorzugsweise weist das Verriegelungsmittel 101 einen dritten Nasenabschnitt 107 auf, der zwischen dem ersten Nasenabschnitt 113 und der Führungsnut 108 angeordnet ist. Bei geschlossenem Deckelteil 104 berührt der zweite Nasenabschnitt 106 das Verriegelungsmittel 101 zwischen dem ersten und dritten Nasenabschnitt (113, 107).

Vorzugsweise weist das Elektrogerät zwei gleichartige Verriegelungsmittel (108, 110) auf, in die jeweils ein Wandungsabschnitt des Deckelteils 104 einklipsbar ist.

In einem weiteren nicht dargestellten Ausführungsbeispiel weist die dritte Ausführungsform Merkmale der ersten und/oder zweiten Ausführungsform auf, wie zum Beispiel die Gelenkaufnahme 32 mit dem Lagerabschnitt 31 und den Gelenkabschnitt 3 mit dem Zapfen 30, das Abdeckteil 52, das Einschubführungsteil 12 und die Nut 15 für das Typenschild 6, das Bedienteil 62 und/oder die Ausnehmung 53 für ein Gegensteckverbinderteil 56.

In einem weiteren nicht dargestellten Ausführungsbeispiel weist die erste Ausführungsform des Elektrogeräts ein Bedienteil 62 auf, wie es im zweiten Ausführungsbeispiel beschrieben ist.

In einem weiteren nicht dargestellten Ausführungsbeispiel weist die erste Ausführungsform des Elektrogeräts ein Deckelteil 4 und ein Abdeckteil 52 auf, wie sie im zweiten Ausführungsbeispiel beschrieben sind.

In einem weiteren nicht dargestellten Ausführungsbeispiel weist die erste Ausführungsform des Elektrogeräts ein Deckelteil 4 aufweisend Ausnehmungen (53, 64) auf, wie es im zweiten Ausführungsbeispiel beschrieben ist.

### Bezugszeichenliste

1 Umrichter
2 Ausnehmungen, insbesondere Lüftungsschlitze
3 Gelenkabschnitt
4 Deckelteil
5 Abdeckteil
6 Typenschild
7 Ausnehmung
8 Gegensteckverbinderteil, insbesondere elektrisches Gegensteckverbinderteil
9 Ausnehmung
10 Kabelführung
11 Gehäuseteil
12 Einschubführungsteil
13 Steckverbinderteil, insbesondere elektrisches Steckverbinderteil
14 Gehäuseteil
15 Nut
20 Vorsprung
21 Steckverbinderteil, insbesondere elektrisches Steckverbinderteil
22 Kabel
23 Verriegelungsmittel
24 Verriegelungsmittel
25 Gehäuseteil
26 Kabelführung
30 Zapfen
31 Lagerabschnitt
32 Gelenkaufnahme
40 Nasenabschnitt
41 Begrenzungsmittel
42 Verbreiterungsabschnitt
49 Umrichter
50 Zapfen
51 Lagerabschnitt
52 Abdeckteil
53 Ausnehmung
54 Verbindungsmittel, insbesondere Klipsverbinder
55 Steckverbinderteil, insbesondere elektrisches Steckverbinderteil
56 Gegensteckverbinderteil, insbesondere elektrisches Gegensteckverbinderteil
57 Verbindungsmittel, insbesondere Schraubteil
58 Kabelführung
59 Typenschild
60 Einschubführungsteil
61 Gehäuseteil
62 Bedienteil
63 Deckelteil
64 Ausnehmung
65 Gelenkabschnitt
66 Steckverbinderteil, insbesondere elektrisches Steckverbinderteil
67 Gehäuseteil
68 Nut
70 Verbindungsmittel, insbesondere Klipsverbinder
71 Gelenkaufnahme
80 Verbindungsmittel, insbesondere Gewindeteil
101 Verriegelungsmittel, insbesondere Klipsverbinder
102 Verriegelungsmittel, insbesondere Klipsverbinder
103 Ausnehmung, insbesondere Bohrung
104 Deckelteil
105 Fase, insbesondere Einfädelfase
106 Nasenabschnitt
107 Nasenabschnitt
108 Führungsnut
109 Ausnehmung
110 Führungsnut
111 Gehäuseteil
112 Befestigungsabschnitt
113 Nasenabschnitt
114 Vorsprung
115 Verbindungsabschnitt
116 Aussparung, insbesondere Schlitz
117 Fase, insbesondere Einfädelfase
118 Vertiefung
125 Gehäuseteil

## Patentansprüche

1. Elektrogerät, insbesondere Umrichter (1), aufweisend ein Gehäuse und ein Deckelteil (104)
wobei das Deckelteil (104) an dem Gehäuse schwenkbar gelagert ist, insbesondere wobei das Deckelteil (104) lösbar mit dem Gehäuse verbunden ist,
indem das Deckelteil (104) einen Zapfen (30) aufweist, der in einem Lagerabschnitt (31), insbesondere einer Vertiefung, des Gehäuses, aufgenommen ist,
wobei ein Verriegelungsmittel (101) mit einem Gehäuseteil (125) des Gehäuses formschlüssig verbunden ist, insbesondere klipsverbunden,
wobei das Deckelteil (104) mittels des Verriegelungsmittels (101) am Gehäuse verriegelbar ist, insbesondere mit dem Verriegelungsmittel (101) klipsverbindbar ist, **dadurch gekennzeichnet, dass** das Verriegelungsmittel (101) zwei Führungsnuten (108, 110) aufweist, mittels derer das Verriegelungsmittel (101) in einer schlitzförmigen Ausnehmung in dem Gehäuseteil (125) geführt ist,
wobei das Verriegelungsmittel (101) einen Vorsprung (114) aufweist,
wobei das Gehäuseteil (125) eine Ausnehmung (103), insbesondere Bohrung, aufweist, wobei der Vorsprung (114) in die Ausnehmung (103) einführbar, insbesondere einpressbar, ist und/oder von einem elastisch vorgespannten Bereich des Verriegelungsmittels (101) hineingedrückt ist,
insbesondere wodurch die Beweglichkeit des Verriegelungsmittels (101) in der Erstreckungsrichtung der Führungsnuten (108, 110) begrenzt ist,
wobei der Vorsprung (114) beabstandet ist von den Führungsnuten (108, 110).

2. Elektrogerät nach Anspruch 1 **dadurch gekennzeichnet, dass**
die Führungsnuten (108, 110) parallel angeordnet sind,
insbesondere wobei die Führungsnuten (108, 110) jeweils eine Nutöffnung aufweisen, wobei die Nutöffnungen entgegengesetzt gerichtet sind.

3. Elektrogerät nach mindestens einem der Ansprüche 1 bis 2,
**dadurch gekennzeichnet, dass**
das Verriegelungsmittel einen Befestigungsabschnitt (112) aufweist,
wobei der Befestigungsabschnitt (112) sich von den Führungsnuten zu dem Vorsprung (114) erstreckt, insbesondere parallel zum Gehäuseteil (125) sich erstreckt,
wobei der Befestigungsabschnitt (112) elastisch auslenkbar ist in einer ersten Querrichtung zur Erstreckungsrichtung der Führungsnuten (108, 110),
insbesondere wobei das Verriegelungsmittel (101) in der ersten Querrichtung begrenzt ist von dem in die Führungsnuten (108, 110) hineinragenden Gehäuseteil (125).

4. Elektrogerät nach mindestens einem der Ansprüche 1 bis 3,
**dadurch gekennzeichnet, dass**
das Verriegelungsmittel (101) einen Verbindungsabschnitt (115) aufweist,
wobei der Verbindungsabschnitt elastisch auslenkbar ist, insbesondere relativ zu den Führungsnuten (108, 110), in einer zweiten Querrichtung zur Erstreckungsrichtung der Führungsnuten (108, 110), insbesondere wobei die zweite Querrichtung quer zur ersten Querrichtung orientiert ist,
insbesondere wobei das Verriegelungsmittel (101) eine sich in Erstreckungsrichtung der Führungsnuten erstreckendende Aussparung (116) aufweist, insbesondere eine schlitzförmige Aussparung (116),
insbesondere wobei die Aussparung (116) zwischen den Führungsnuten (108, 110) angeordnet ist,
insbesondere wobei der Verbindungsabschnitt (115) und der Befestigungsabschnitt (112) senkrecht zueinander angeordnet sind.

5. Elektrogerät nach mindestens einem der Ansprüche 1 bis 4,
**dadurch gekennzeichnet, dass**
das Verriegelungsmittel (101) und/oder das Deckelteil (104) aus Kunststoff ausgeführt sind, insbesondere als Kunststoffspritzgussteil,
und/oder dass
das Gehäuseteil (125) aus metallischem Material ausgeführt ist,
und/oder dass
der Lagerabschnitt (31) des Gehäuses aus Kunststoff ausgeführt ist, insbesondere als Kunststoffspritzgussteil.

6. Elektrogerät nach mindestens einem der Ansprüche 4 bis 5,
**dadurch gekennzeichnet, dass**
der Verbindungsabschnitt (115) einen ersten Nasenabschnitt (113) aufweist,
wobei das Deckelteil (104) einen zweiten Nasenabschnitt (106) und eine an den zweiten Nasenabschnitt anschließende Vertiefung (118) aufweist, in die der erste Nasenabschnitt (113) einklipsbar ist,
insbesondere wobei der erste Nasenabschnitt (113) den zweiten Nasenabschnitt (106) in einer Schwenkrichtung des Deckelteils (104) begrenzt.

7. Elektrogerät nach Anspruch 6,
**dadurch gekennzeichnet, dass**
der erste Nasenabschnitt (113) eine Fase (105) aufweist, insbesondere eine Einfädelfase für das Deckelteil (104),
und/oder dass
der zweite Nasenabschnitt (106) eine Fase (117) aufweist, insbesondere eine Einfädelfase für das Verriegelungsmittel (101).

8. & Elektrogerät nach mindestens einem der Ansprüche 6 bis 7,
**dadurch gekennzeichnet, dass**
der Verbindungsabschnitt (115) einen dritten Nasenabschnitt (106) aufweist, der zwischen dem ersten Nasenabschnitt (113) und einer der Führungsnuten (108) angeordnet ist,
insbesondere wobei der erste Nasenabschnitt (113) und der dritte Nasenabschnitt (107) voneinander beabstandet sind.

9. Elektrogerät nach mindestens einem der Ansprüche 1 bis 8,
**dadurch gekennzeichnet, dass**
das Deckelteil (104) einen Grundkörper und einen Gelenkabschnitt (3) aufweist, der aus dem Grundkörper auskragt,
wobei der Zapfen (30) an dem Gelenkabschnitt (3) angeordnet ist und beabstandet ist vom Grundkörper,
insbesondere wobei Grundkörper, Zapfen (30) und Gelenkabschnitt (3) einstückig ausgeführt sind, insbesondere als Kunststoffspritzgussteil.

10. Elektrogerät nach Anspruch 9,
**dadurch gekennzeichnet, dass**
das Gehäuse eine Gelenkaufnahme (32) aufweist,
wobei der Gelenkabschnitt (3) des Deckelteils (104) in der Gelenkaufnahme (32) aufgenommen ist und in axialer Richtung relativ zur Schwenkachse begrenzt ist von der Gelenkaufnahme (32),
insbesondere wobei der Lagerabschnitt (31) als Vertiefung in der Gelenkaufnahme (32) ausgeführt ist,
insbesondere wobei die Gelenkaufnahme (32) als gestufte Vertiefung ausgeführt ist.

11. Elektrogerät nach mindestens einem der Ansprüche 1 bis 10,
**dadurch gekennzeichnet, dass**
das Deckelteil (104) eine erste Ausnehmung aufweist, die mit einem Abdeckteil (52) verschließbar ist,
wobei das Deckelteil (104) mit dem Abdeckteil (52) lösbar verbunden ist, insbesondere klipsverbunden,
wobei das Abdeckteil (52) bei verriegeltem Deckelteil (104) das Verriegelungsmittel (101) abdeckt,
insbesondere wobei das Abdeckteil (52) bei verriegeltem Deckelteil (104) ein Steckverbinderteil (55) abdeckt.

12. Elektrogerät nach mindestens einem der Ansprüche 1 bis 11,
**dadurch gekennzeichnet, dass**
das Gehäuse ein Einschubführungsteil (12) aufweist, in das ein Typenschild (6) einschiebbar ist,
wobei das Deckelteil (104) eine Nut (15) aufweist,
wobei bei verriegeltem Deckelteil (104) das Typenschild (6) in der Nut (15) angeordnet, insbesondere aufgenommen, ist,
insbesondere wobei ein Gehäuseteil (111) des Gehäuses mit dem Einschubführungsteil (12) verbunden ist, wobei das Gehäuseteil (111) als Metallteil ausgeführt ist und/oder das Typenschild (6) und/oder das Einschubführungsteil (12) als Kunststoffteil ausgeführt sind.

13. Elektrogerät nach mindestens einem der Ansprüche 1 bis 12,
**dadurch gekennzeichnet, dass**
ein Bedienteil (62) lösbar mit dem Gehäuse verbunden ist, insbesondere klipsverbunden,
wobei das Deckelteil (104) eine zweite Ausnehmung (64) aufweist, durch die das Bedienteil (62) hindurchbedienbar ist,
wobei das Deckelteil (104) das Bedienteil (62) am Gehäuse sichert, insbesondere hält,

14. Elektrogerät nach mindestens einem der Ansprüche 1 bis 13,
**dadurch gekennzeichnet, dass**
das Deckelteil (104) eine dritte Ausnehmung (53) aufweist,
wobei am Elektrogerät ein weiteres Steckverbinderteil angeordnet ist, das durch die dritte Ausnehmung (53) hindurch zugänglich ist, insbesondere für ein Gegensteckverbinderteil (56), insbesondere so dass das Gegensteckverbinderteil (56) zur Verbindung mit dem weiteren Steckverbinderteil durch die dritte Ausnehmung (53) hindurch führbar ist und steckverbindbar ist mit dem Steckverbinderteil, insbesondere bei verriegeltem Deckelteil (104).

## Claims

1. Electrical device, in particular a converter (1), comprising a housing and a lid part (104),
the lid part (104) being pivotally mounted on the housing, the lid part (104) in particular being detachably connected to the housing by the lid part (104) having a pin (30) that is received in a bearing portion (31), in particular a notch, of the housing,
a locking means (101) being form-fittingly connected, in particular clipped, to a housing part (125) of the housing,
the lid part (104) being lockable on the housing by means of the locking means (101), in particular being clippable to the locking means (101),
**characterised in that**
the locking means (101) has two guide grooves (108, 110) by means of which the locking means (101) is guided in a slot-like recess in the housing part (125),
the locking means (101) having a projection (114),
the housing part (125) having a recess (103), in particular a drilled hole,
the projection (114) being insertable, in particular pressable, into the recess (103) and/or being pushed therein by a resiliently preloaded region of the locking means (101),
whereby in particular the movement of the locking means (101) in the extension direction of the guide grooves (108, 110) is limited,
the projection (114) being spaced apart from the guide grooves (108, 110).

2. Electrical device according to claim 1,
**characterised in that**
the guide groove (108, 110) are arranged in parallel,
the guide grooves (108, 110) in particular each having a groove opening, the groove openings facing in opposite directions.

3. Electrical device according to at least one of claims 1 to 2,
**characterised in that**
the locking means has a fastening portion (112),
the fastening portion (112) extending from the guide grooves to the projection (114), in particular in parallel with the housing part (125),
the fastening portion (112) being resiliently deflectable in a first transverse direction to the extension direction of the guide grooves (108, 110),
the locking means (101) in particular being limited in the first transverse direction by the housing part (125) protruding into the guide grooves (108, 110).

4. Electrical device according to at least one of claims 1 to 3,
**characterised in that**
the locking means (101) has a connecting portion (115),
the connecting portion being resiliently deflectable, in particular relative to the guide grooves (108, 110), in a second transverse direction to the extension direction of the guide grooves (108, 110), the second transverse direction in particular being oriented transversely to the first transverse direction,
the locking means (101) in particular having a cut-out (116), in particular a slot-like cut-out (116), extending in the extension direction of the guide grooves,
the cut-out (116) in particular being arranged between the guide grooves (108, 110),
the connecting portion (115) and the fastening portion (112) in particular being arranged perpendicularly to one another.

5. Electrical device according to at least one of claims 1 to 4,
**characterised in that**
the locking means (101) and/or the lid part (104) are made of plastics material, in particular as a plastics injection-moulded part,
and/or **in that**
the housing part (125) is made of metal material,
and/or **in that**
the bearing portion (31) of the housing is made of plastics material, in particular as a plastics injection-moulded part.

6. Electrical device according to at least one of claims 4 to 5,
**characterised in that**
the connecting portion (115) has a first lug portion (113),
the lid part (104) having a second lug portion (106) and a notch (118) that adjoins the second lug portion and into which the first lug portion (113) can be clipped,
the first lug portion (113) in particular limiting the second lug portion (106) in a pivoting direction of the lid part (104).

7. Electrical device according to claim 6,
**characterised in that**
the first lug portion (113) has a chamfer (105), in particular a thread-in chamfer for the lid part (104),
and/or **in that**
the second lug portion (106) has a chamfer (117), in particular a thread-in chamfer for the locking means (101).

8. Electrical device according to at least one of claims 6 to 7,
**characterised in that**
the connecting portion (115) has a third lug portion (106) arranged between the first lug portion (113) and one of the guide grooves (108),
the first lug portion (113) and the third lug portion (107) in particular being spaced apart from one another.

9. Electrical device according to at least one of claims 1 to 8,
**characterised in that**
the lid part (104) has a main body and a joint portion (3) projecting from the main body,
the pin (30) being arranged on the joint portion (3) and being spaced apart from the main body,
the main body, the pin (30) and the joint portion (3) in particular being formed in one piece, in particular as a plastics injection-moulded part.

10. Electrical device according to claim 9,
**characterised in that**
the housing has a joint receptacle (32),
the joint portion (3) of the lid part (104) is received in the joint receptacle (32) and is limited by the joint receptacle (32) in the axial direction relative to the pivot axis,
the bearing portion (31) in particular being configured as a notch in the joint receptacle (32), the joint receptacle (32) in particular being configured as a stepped notch.

11. Electrical device according to at least one of claims 1 to 10,
**characterised in that**
the lid part (104) has a first recess that can be closed by a cover part (52),
the lid part (104) being detachably connected, in particular clipped, to the cover part (52), the cover part (52) covering the locking means (101) when the lid part (104) is locked,
the cover part (52) in particular covering a plug-in connector part (55) when the lid part (104) is locked.

12. Electrical device according to at least one of claims 1 to 11,
**characterised in that**
the housing has an slide-in guide part (12) into which a rating plate (6) can be slid,
the lid part (104) having a groove (15),
the rating plate (6) being arranged, in particular received, in the groove (15) when the lid part (104) is locked,
a housing part (111) of the housing in particular being connected to the slide-in guide part (12), the housing part (111) being configured as a metal part and/or the rating plate (6) and/or the slide-in guide part (12) being configured as a plastics part.

13. Electrical device according to at least one of claims 1 to 12,
**characterised in that**
an operating part (62) is detachably connected, in particular clipped, to the housing,
the lid part (104) having a second recess (64) through which the operating part (62) can be operated,
the lid part (104) securing, in particular retaining, the operating part (62) on the housing.

14. Electrical device according to at least one of claims 1 to 13,
**characterised in that**
the housing part (104) has a third recess (53),
a further plug-in connector part being arranged on the electrical device and being accessible through the third recess (53), in particular for a mating plug-in connector part (56), in particular such that the mating plug-in connector part (56) can be guided through the third recess (53) for connection to the further plug-in connector part and plugged to the plug-in connector part, in particular when the lid part (104) is locked.

## Revendications

1. Appareil électrique, en particulier onduleur (1) comprenant un boîtier et une partie (104) formant couvercle,
laquelle partie (104) formant couvercle est montée à pivotement sur le boîtier, sachant que ladite partie (104) formant couvercle est notamment reliée audit boîtier de manière libérable
du fait que ladite partie (104) formant couvercle est munie d'un téton (30) logé dans une zone de montage (31), en particulier dans un renfoncement dudit boîtier,
un moyen de verrouillage (101) étant relié à une partie (125) dudit boîtier par complémentarité de formes, notamment par clipsage,
ladite partie (104) formant couvercle pouvant être verrouillée sur ledit boîtier à l'aide dudit moyen de verrouillage (101) et pouvant, notamment, être reliée par clipsage audit moyen de verrouillage (101), **caractérisé par le fait que**
le moyen de verrouillage (101) comporte deux rainures de guidage (108, 110) à l'aide desquelles ledit moyen de verrouillage (101) est guidé dans un évidement en forme de fente, pratiqué dans ladite partie (125) du boîtier,
ledit moyen de verrouillage (101) étant pourvu d'une saillie (114),
ladite partie (125) du boîtier étant dotée d'un évidement (103), en particulier d'un perçage,
ladite saillie (114) pouvant être insérée dans ledit évidement (103), en particulier par emmanchement à force, et/ou étant enfoncée par une région du moyen de verrouillage (101) précontrainte élastiquement,
ce qui a notamment pour effet de limiter la mobilité dudit moyen de verrouillage (101) dans la direction de l'étendue des rainures de guidage (108, 110),
ladite saillie (114) étant située à distance desdites rainures de guidage (108, 110).

2. Appareil électrique selon la revendication 1,
**caractérisé par le fait que**
les rainures de guidage (108, 110) sont disposées parallèlement,
sachant notamment que lesdites rainures de guidage (108, 110) sont respectivement munies d'une ouverture, les ouvertures desdites rainures étant dirigées dans des sens opposés.

3. Appareil électrique selon au moins l'une des revendications 1 à 2,
**caractérisé par le fait que**
le moyen de verrouillage est pourvu d'une zone de fixation (112),
laquelle zone de fixation (112) s'étend jusqu'à la saillie (114) à partir des rainures de guidage et s'étend, en particulier, parallèlement à la partie (125) du boîtier,
ladite zone de fixation (112) pouvant être déviée élastiquement dans une première direction transversale par rapport à la direction de l'étendue des rainures de guidage (108, 110),
sachant notamment que le moyen de verrouillage (101) est limité, dans ladite première direction transversale, par ladite partie (125) du boîtier pénétrant dans lesdites rainures de guidage (108, 110).

4. Appareil électrique selon au moins l'une des revendications 1 à 3,
**caractérisé par le fait que**
le moyen de verrouillage (101) est muni d'une zone de liaison (115),
laquelle zone de liaison (115) peut être déviée élastiquement, notamment vis-à-vis des rainures de guidage (108, 110), dans une seconde direction transversale par rapport à la direction de l'étendue desdites rainures de guidage (108, 110), laquelle seconde direction transversale est orientée, en particulier, transversalement par rapport à la première direction transversale,
sachant notamment que ledit moyen de verrouillage (101) comporte une échancrure (116) s'étendant dans la direction de l'étendue des rainures de guidage, en particulier une échancrure (116) en forme de fente,
laquelle échancrure (116) est notamment interposée entre lesdites rainures de guidage (108, 110),
sachant notamment que ladite zone de liaison (115) et la zone de fixation (112) sont disposées perpendiculairement l'une à l'autre.

5. Appareil électrique selon au moins l'une des revendications 1 à 4,
**caractérisé par le fait que**
le moyen de verrouillage (101) et/ou la partie (104) formant couvercle est (sont) réalisé(e)(s) en matière plastique, notamment en tant que pièce en matière plastique moulée par injection ;
et/ou que
la partie (125) dudit boîtier est réalisée en un matériau métallique ;
et/ou que
la zone de montage (31) dudit boîtier est réalisée en matière plastique, notamment en tant que pièce en matière plastique moulée par injection.

6. Appareil électrique selon au moins l'une des revendications 4 à 5,
**caractérisé par le fait que**
la zone de liaison (115) est munie d'une première région protubérante (113),
la partie (104) formant couvercle comprenant une deuxième région protubérante (106), et un renfoncement (118) qui est attenant à ladite deuxième région protubérante et dans lequel ladite première région protubérante (113) peut être clipsée,
sachant notamment que ladite première région protubérante (113) limite ladite deuxième région protubérante (106) dans une direction de pivotement de ladite partie (104) formant couvercle.

7. Appareil électrique selon la revendication 6,
**caractérisé par le fait que**
la première région protubérante (113) est pourvue d'un biseau (105), en particulier d'un biseau d'introduction affecté à la partie (104) formant couvercle ;
et/ou que
la deuxième région protubérante (106) est pourvue d'un biseau (117), en particulier d'un biseau d'introduction affecté au moyen de verrouillage (101).

8. Appareil électrique selon au moins l'une des revendications 6 à 7,
**caractérisé par le fait que**
la zone de liaison (115) est dotée d'une troisième région protubérante (107) interposée entre la première région protubérante (113) et l'une (108) des rainures de guidage, sachant notamment que ladite première région protubérante (113) et ladite troisième région protubérante (107) sont distantes l'une de l'autre.

9. Appareil électrique selon au moins l'une des revendications 1 à 8,
**caractérisé par le fait que**
la partie (104) formant couvercle comprend un corps de base et une région articulée (3) faisant saillie au-delà dudit corps de base,
le téton (30) étant disposé sur ladite région articulée (3) et étant espacé dudit corps de base,
sachant notamment que ledit corps de base, ledit téton (30) et ladite région articulée (3) sont réalisés d'un seul tenant, en particulier sous la forme d'une pièce en matière plastique moulée par injection.

10. Appareil électrique selon la revendication 9,
**caractérisé par le fait que**
le boîtier comporte un logement d'articulation (32),
la région articulée (3) de la partie (104) formant couvercle étant reçue par ledit logement d'articulation (32) et étant limitée par ledit logement d'articulation (32), dans la direction axiale, par rapport à l'axe de pivotement,
la zone de montage (31) étant notamment réalisée sous la forme d'un renfoncement ménagé dans ledit logement d'articulation (32),
lequel logement d'articulation (32) est notamment réalisé sous la forme d'un renfoncement étagé.

11. Appareil électrique selon au moins l'une des revendications 1 à 10,
**caractérisé par le fait que**
la partie (104) formant couvercle est munie d'un premier évidement pouvant être obturé par une partie de recouvrement (52),
ladite partie (104) formant couvercle étant reliée à ladite partie de recouvrement (52) de manière libérable, notamment reliée par clipsage,
ladite partie de recouvrement (52) recouvrant le moyen de verrouillage (101) à l'état verrouillé de ladite partie (104) formant couvercle,
sachant notamment que ladite partie de recouvrement (52) recouvre une partie (55) de connexion enfichable à l'état verrouillé de ladite partie (104) formant couvercle.

12. Appareil électrique selon au moins l'une des revendications 1 à 11,
**caractérisé par le fait que**
le boîtier comporte une partie (12) de guidage d'insertion, dans laquelle une plaquette signalétique (6) peut être insérée,
la partie (104) formant couvercle étant munie d'une rainure (15),
sachant que ladite plaquette signalétique (6) est disposée, notamment logée dans ladite rainure (15) à l'état verrouillé de ladite partie (104) formant couvercle,
sachant notamment qu'une partie (111) du boîtier est reliée à ladite partie (12) de guidage d'insertion, ladite partie (111) du boîtier étant réalisée en tant que pièce en métal, et/ou ladite plaquette signalétique (6) et/ou ladite partie (12) de guidage d'insertion étant réalisée(s) sous la forme d'une pièce en matière plastique.

13. Appareil électrique selon au moins l'une des revendications 1 à 12,
**caractérisé par le fait**
**qu'**une partie d'actionnement (62) est reliée au boîtier de manière libérable, notamment reliée par clipsage,
la partie (104) formant couvercle étant dotée d'un deuxième évidement (64), à travers lequel ladite partie d'actionnement (62) peut être manœuvrée,
sachant que ladite partie (104) formant couvercle assure l'arrêt, en particulier la retenue de ladite partie d'actionnement (62) sur ledit boîtier.

14. Appareil électrique selon au moins l'une des revendications 1 à 13,
**caractérisé par le fait que**
la partie (104) formant couvercle est pourvue d'un troisième évidement (53),
sachant qu'une partie supplémentaire de connexion enfichable est disposée sur ledit appareil électrique et est accessible à travers ledit troisième évidement (53), notamment pour une partie complémentaire (56) de connexion enfichable, en particulier de façon telle que ladite partie complémentaire (56) de connexion enfichable puisse être guidée à travers ledit troisième évidement (53), en vue de la jonction avec la partie additionnelle de connexion enfichable, et puisse être connectée par enfichage à ladite partie de connexion enfichable, notamment à l'état verrouillé de ladite partie (104) formant couvercle.
